# EUROPEAN PATENT APPLICATION

(11) **EP 4 489 078 A2**
(43) Date of publication of application: **08.01.2025**
(21) Application number: 24166337.6
(22) Date of filing: 26.03.2024
(51) Int. Cl.: H01L 29/06, H01L 29/423, H01L 29/66, H01L 29/775, H01L 29/786, H01L 27/088, H01L 21/8234, H01L 27/092, H01L 21/8238

(54) **SEMICONDUCTOR DEVICE WITH INNER SPACER AND METHOD OF FABRICATING THE SAME**

(30) Priority: 06.07.2023 KR 20230087768
(71) Applicant: Samsung Electronics Co., Ltd., Suwon-si, Gyeonggi-do 16677 (KR)
(72) Inventor: PARK, Beomjin, 16677 Suwon-si (KR); KANG, Myung Gil, 16677 Suwon-si (KR); KIM, Dongwon, 16677 Suwon-si (KR); KIM, Younggwon, 16677 Suwon-si (KR); KIM, Jongsu, 16677 Suwon-si (KR); YOO, Hyumin, 16677 Suwon-si (KR); JEONG, Soojin, 16677 Suwon-si (KR)
(74) Representative: Marks & Clerk LLP

(57) **Abstract**

The present disclosure relates to semiconductor devices and their fabrication methods. A semiconductor device comprises a substrate including an active pattern (AP1), a channel pattern including semiconductor patterns (SP1 .. SP3), a source/drain pattern (SD1) connected to the semiconductor patterns, an inner gate electrode (IGE2, IGE3) between two neighboring semiconductor patterns, an inner gate dielectric layer (IIL), and an inner high-k dielectric layer between the inner gate electrode and the inner gate dielectric layer. The inner gate dielectric layer includes an upper dielectric layer (IILT), a lower dielectric layer (IILB), and an inner spacer (ISP). A first thickness (TH1) of the inner spacer is greater than a second thickness (TH2) of the upper or lower dielectric layer. The first thickness is greater than a third thickness (TH3) of the inner high-k dielectric layer.

## Description

### BACKGROUND

A semiconductor device includes an integrated circuit including metal oxide semiconductor field effect transistors (MOSFETs). As sizes and design rules of the semiconductor device are gradually decreased, sizes of the MOSFETs are also increasingly scaled down. The scale down of MOSFETs may deteriorate operating characteristics of the semiconductor device. Accordingly, various studies have been conducted to develop methods of fabricating semiconductor devices having superior performances while overcoming limitations caused by high integration of the semiconductor devices.

### SUMMARY

The present disclosure relates to semiconductor devices, including a semiconductor device with increased reliability and improved electrical properties, as well as methods of fabricating the same.

In some implementations, a semiconductor device comprises: a substrate that includes an active pattern; a channel pattern on the active pattern, wherein the channel pattern includes a plurality of semiconductor patterns that are vertically stacked and spaced apart from each other; a source/drain pattern connected to the plurality of semiconductor patterns; an inner gate electrode between neighboring first and second ones of the plurality of semiconductor patterns; an inner gate dielectric layer between the inner gate electrode and the plurality of semiconductor patterns; and an inner high-k dielectric layer between the inner gate electrode and the inner gate dielectric layer. The inner gate dielectric layer may include: an upper dielectric layer between the inner gate electrode and the second semiconductor pattern; a lower dielectric layer between the inner gate electrode and the first semiconductor pattern; and an inner spacer between the inner gate electrode and the source/drain pattern. A first thickness of the inner spacer may be greater than a second thickness of the upper dielectric layer or the lower dielectric layer. The first thickness may be greater than a third thickness of the inner high-k dielectric layer.

In some implementations, a semiconductor device comprises: a substrate that includes an active pattern; a channel pattern on the active pattern, wherein the channel pattern includes a plurality of semiconductor patterns that are vertically stacked and spaced apart from each other; a source/drain pattern connected to the plurality of semiconductor patterns; a gate electrode on the plurality of semiconductor patterns, wherein the gate electrode includes an inner gate electrode between neighboring ones of the plurality of semiconductor patterns and an outer gate electrode on an uppermost one of the plurality of semiconductor patterns; and an inner spacer between the inner gate electrode and the source/drain pattern. Each of the plurality of semiconductor patterns may have a first lattice constant. The source/drain pattern may have a second lattice constant. The inner spacer may have a third lattice constant. The second lattice constant may be the same as the first lattice constant and greater than the third lattice constant.

Lattice constant is defined to indicate a minimum distance between atoms included in the respective element, e.g., each semiconductor pattern, source/drain pattern and inner spacer.

The second lattice constant may be equal to the first lattice constant. The second lattice constant may be greater than the third lattice constant.

In some implementations, a semiconductor device comprises: a substrate that includes first, second, third, and fourth regions; a plurality of first semiconductor patterns that are vertically stacked and spaced apart from each other on the first region; a plurality of second semiconductor patterns that are vertically stacked and spaced apart from each other on the second region; a plurality of third semiconductor patterns that are vertically stacked and spaced apart from each other on the third region; a plurality of fourth semiconductor patterns that are vertically stacked and spaced apart from each other on the fourth region; a first inner electrode between the first semiconductor patterns; a second inner electrode between the second semiconductor patterns; a third inner electrode between the third semiconductor patterns; a fourth inner electrode between the fourth semiconductor patterns; first, second, third, and fourth high-k dielectric layers on the first, second, third, and fourth inner electrodes, respectively; and a first inner spacer on a sidewall of at least one of the first, second, third, and fourth high-k dielectric layers. A first width of the first semiconductor pattern may be less than a second width of the second semiconductor pattern. A thickness of the first high-k dielectric layer may be less than a thickness of the third high-k dielectric layer.

In some implementations, a method of fabricating a semiconductor device comprises: forming on a substrate a stack pattern including active layers and sacrificial layers that are alternately stacked; forming on the stack pattern a sacrificial pattern that extends in a first direction; using the sacrificial pattern as a mask to etch the stack pattern to form a recess in the stack pattern, wherein the active layers include a plurality of semiconductor patterns exposed by the recess; forming a source/drain pattern in the recess; removing the sacrificial pattern and the sacrificial layers to expose the plurality of semiconductor patterns; forming a gate dielectric layer on the plurality of semiconductor patterns that are exposed; and forming a gate electrode on the gate dielectric layer. The gate dielectric layer may include an inner gate dielectric layer adjacent to an inner gate electrode of the gate electrode and an outer gate dielectric layer adjacent to an outer gate electrode of the gate electrode. The inner gate dielectric layer may include: an upper dielectric layer between the inner gate electrode and a second one of the plurality of semiconductor patterns; a lower dielectric layer between the inner gate electrode and a first one of the plurality of semiconductor patterns; and an inner spacer between the inner gate electrode and the source/drain pattern. A first thickness of the inner spacer may be greater than a second thickness of the upper dielectric layer or the lower dielectric layer.

Inner gate electrode may comprise one of several inner gate electrode of the gate electrode. For example, the gate electrode may comprise first, second and third inner gate electrode. The described inner gate electrode may comprise the second inner gate electrode interposed between the first and third inner gate electrodes.

At least some of the above and other features of the disclosure are set out in the claims.

### BRIEF DESCRIPTION OF THE DRAWINGS

FIGS. 1, 2, and 3 illustrate conceptual views showing logic cells of an example of a semiconductor device.
FIG. 4 illustrates a plan view showing an example of a semiconductor device.
FIGS. 5A, 5B, 5C, and 5D illustrate example cross-sectional views respectively taken along lines A-A', B-B', C-C', and D-D' of FIG. 4.
FIG. 6A illustrates an example enlarged view showing section M of FIG. 5A.
FIG. 6B illustrates an example enlarged view showing section N of FIG. 6A.
FIGS. 7A and 8A illustrate simplified plan views partially showing an example of a semiconductor device.
FIG. 7B illustrates an example cross-sectional view taken along lines A-A', B-B', C-C', and D-D' of FIG. 7A.
FIG. 7C illustrates an example cross-sectional view taken along lines E-E', F-F', G-G', and H-H' of FIG. 7A.
FIG. 8B illustrates an example cross-sectional view taken along lines A-A', B-B', C-C', and D-D' of FIG. 8A.
FIG. 8C illustrates an example cross-sectional view taken along lines E-E', F-F', G-G', and H-H' of FIG. 8A.
FIGS. 9A to 14D illustrate cross-sectional views showing an example of a method of fabricating a semiconductor device.
FIGS. 15, 16, 17, and 18 illustrate enlarged views showing an example of a method of forming section M of FIG. 13A.
FIGS. 19, 20, 21, and 22 illustrate enlarged views showing another example of a method of forming section M of FIG. 13A.

### DETAILED DESCRIPTION

Any references to "upper", "lower", "uppermost" or "lowermost" should be understood as not necessarily imparting a precise orientation of the described elements or features, but rather as referring to a relative location of the described elements or features.

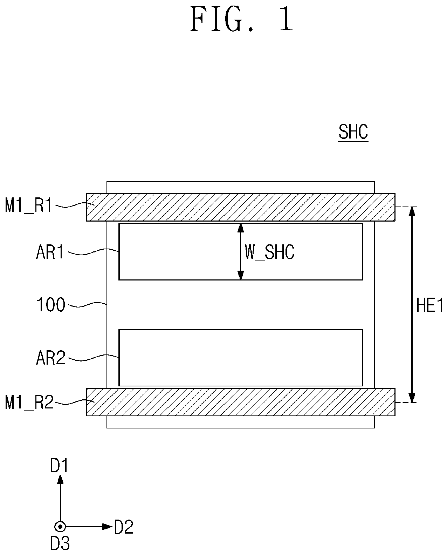

FIGS. 1, 2, and 3 illustrate conceptual views showing logic cells of an example of a semiconductor device.

Referring to FIG. 1, a single height cell SHC is provided. For example, a substrate 100 is provided thereon with a first power line M1_R1 and a second power line M1_R2. The first power line M1_R1 is a path for providing a source voltage (VSS), for example, a ground voltage. The second power line M1_R2 is a path for providing a drain voltage (VDD), for example, a power voltage.

The single height cell SHC may be defined between the first power line M1_R1 and the second power line M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. For example, the single height cell SHC may have a complementary metal oxide semiconductor (CMOS) structure provided between the first power line M1_R1 and the second power line M1_R2. For example, the first active region AR1 may be an NMOSFET region, and the second active region AR2 may be a PMOSFET region.

Each of the first and second active regions AR1 and AR2 may have a single width W_SHC in a first direction D1. A first height HE1 may be defined as a length in the first direction D1 of the single height cell SHC. The first height HE1 may be substantially the same as a distance (e.g., pitch) between the first power line M1_R1 and the second power line M1_R2.

The single height cell SHC may constitute one logic cell. In this description, the logic cell may mean a logic element, such as AND, OR, XOR, XNOR, and inverter, that performs a specific function. For example, the logic cell may include transistors for constituting a logic element, and may also include wiring lines that connect the transistors to each other.

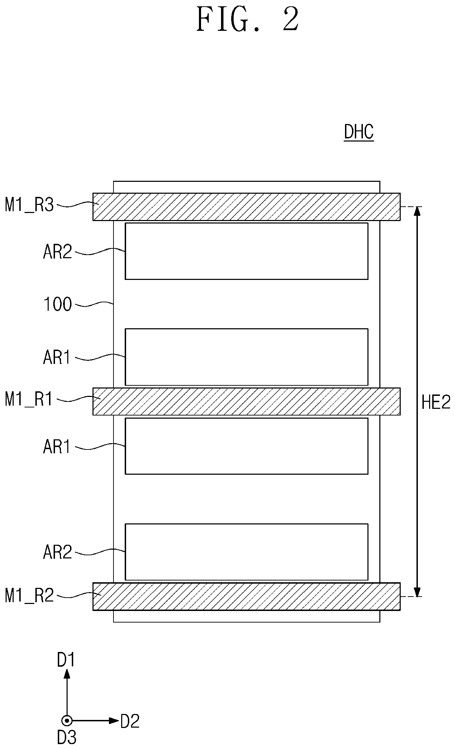

Referring to FIG. 2, a double height cell DHC is provided. For example, a substrate 100 is provided thereon with a first power line M1_R1, a second power line M1_R2, and a third power line M1_R3. The first power line M1_R1 is disposed between the second power line M1_R2 and the third power line M1_R3. The third power line M1_R3 is a path for providing a source voltage (VSS).

The double height cell DHC may be defined between the second power line M1_R2 and the third power line M1_R3. The double height cell DHC may include two first active regions AR1 and two second active regions AR2.

One of the two second active regions AR2 may be adjacent to the second power line M1_R2. The other of the two second active regions AR2 may be adjacent to the third power line M1_R3. The two first active regions AR1 may be adjacent to the first power line M1_R1. When viewed in plan, the first power line M1_R1 may be disposed between the two first active regions AR1.

A second height HE2 may be defined to indicate a length in the first direction D1 of the double height cell DHC. The second height HE2 may be about twice the first height HE1 of FIG. 1. The two first active regions AR1 of the double height cell DHC may be collectively connected to act as one active region.

In the present concepts, the double height cell DHC shown in FIG. 2 may be defined as a multi-height cell. Although not shown, the multi-height cell may include a triple height cell whose cell height is about three times that of the single height cell SHC.

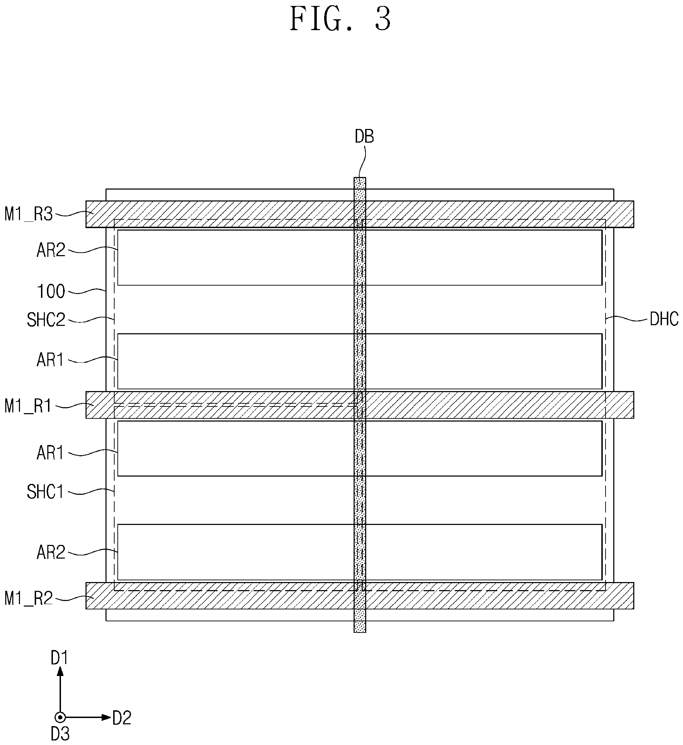

Referring to FIG. 3, a substrate 100 is provided thereon with a first single height cell SHC1, a second single height cell SHC2, and a double height cell DHC that are two-dimensionally disposed. The first single height cell SHC1 is disposed between a first power line M1_R1 and a second power line M1_R2. The second single height cell SHC2 is disposed between the first power line M1_R1 and a third power line M1_R3. The second single height cell SHC2 is adjacent in the first direction D1 to the first single height cell SHC1.

The double height cell DHC may be disposed between the second power line M1_R2 and the third power line M1_R3. The double height cell DHC may be adjacent in a second direction D2 to the first and second single height cells SHC1 and SHC2.

A separation structure DB may be provided between the first single height cell SHC1 and the double height cell DHC and between the second single height cell SHC2 and the double height cell DHC. The separation structure DB may electrically separate an active region of the double height cell DHC from an active region of each of the first and second single height cells SHC1 and SHC2.

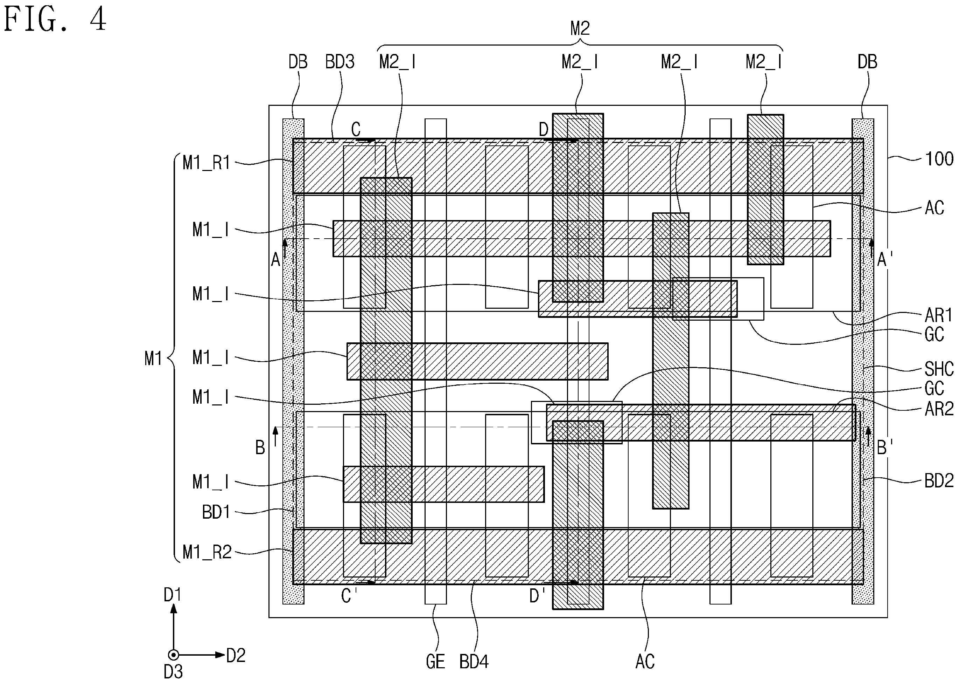

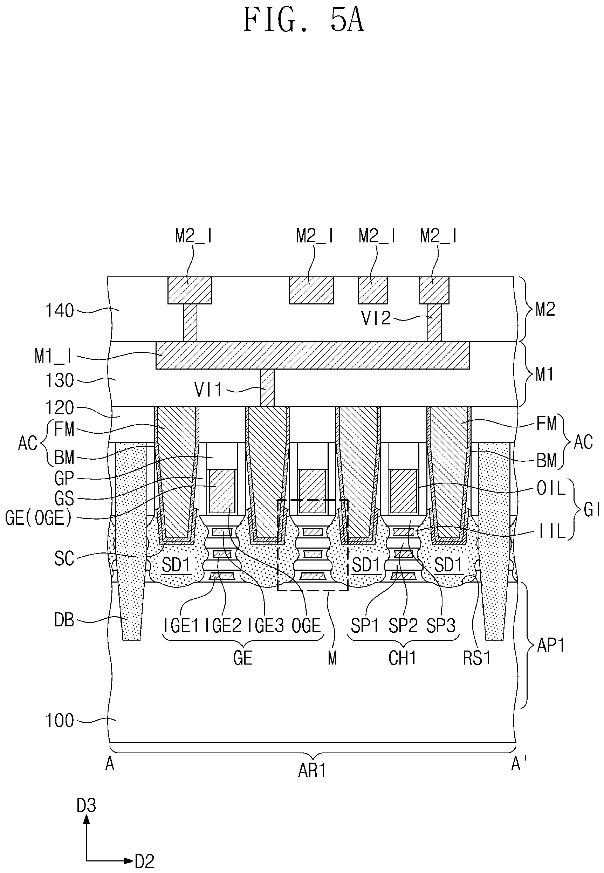

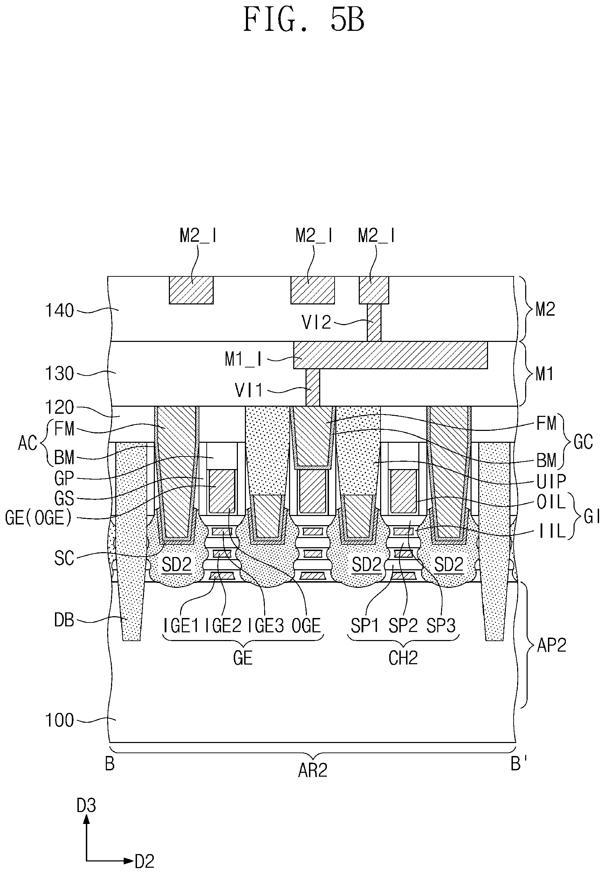

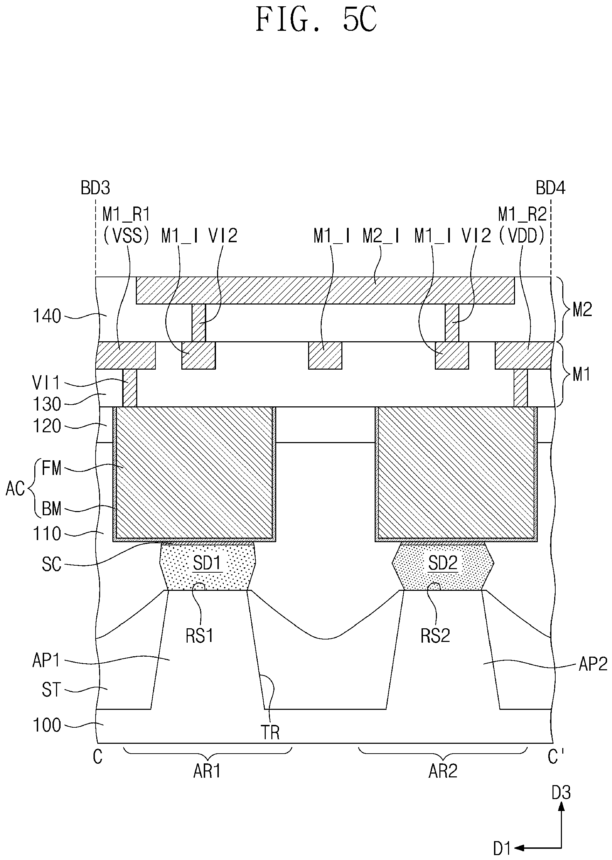

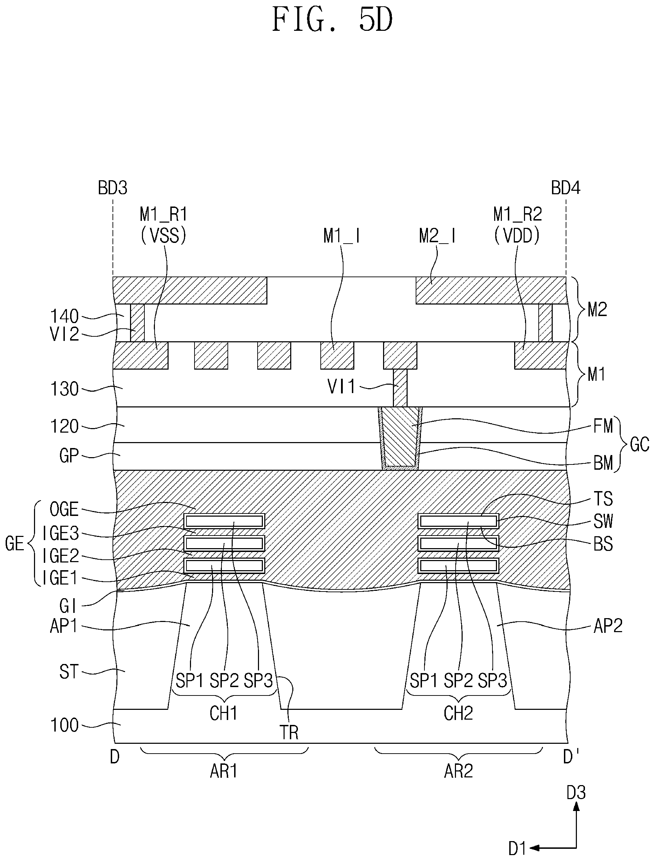

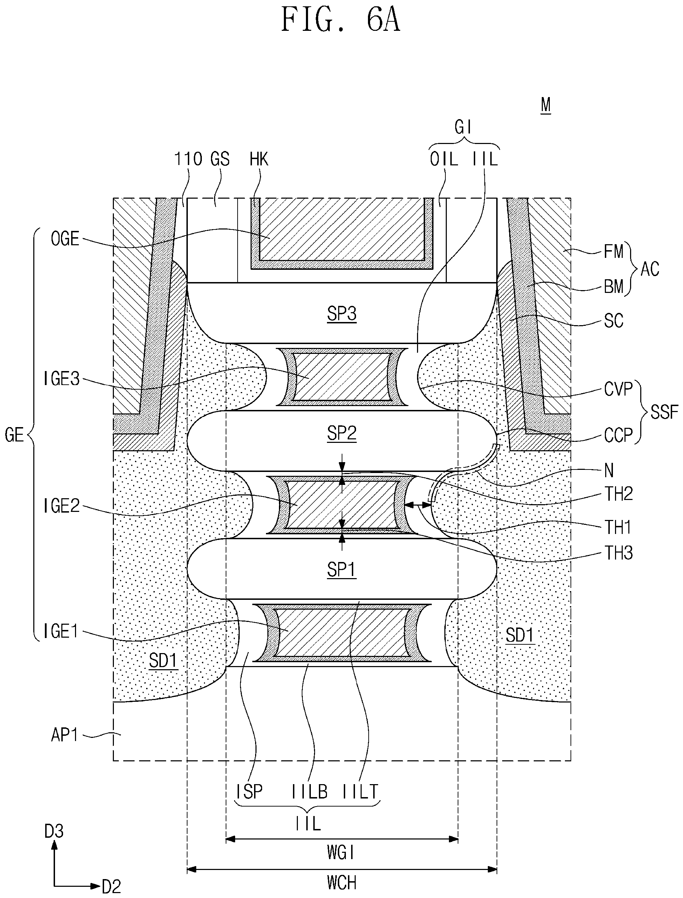

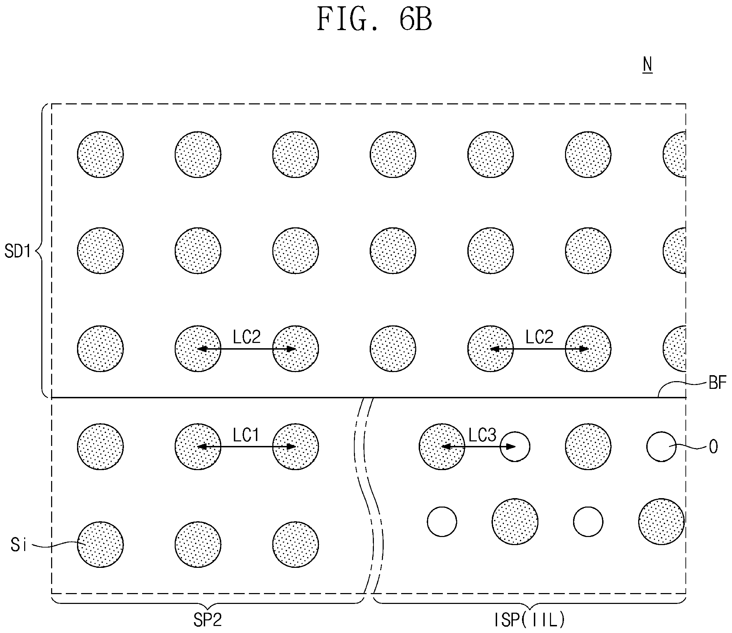

FIG. 4 illustrates a plan view showing an example of a semiconductor device. FIGS. 5A, 5B, 5C, and 5D illustrate example cross-sectional views respectively taken along lines A-A', B-B', C-C', and D-D' of FIG. 4. FIG. 6A illustrates an example enlarged view showing section M of FIG. 5A. FIG. 6B illustrates an example enlarged view showing section N of FIG. 6A. A semiconductor device depicted in FIGS. 4 and 5A to 5D is a detailed example of the single height cell SHC shown in FIG. 1.

Referring to FIGS. 4 and 5A to 5D, a single height cell SHC is provided on a substrate 100. The single height cell SHC is provided thereon with logic transistors included in a logic circuit. The substrate 100 is a compound semiconductor substrate or a semiconductor substrate including silicon, germanium, or silicon-germanium. For example, the substrate 100 is a silicon substrate.

The substrate 100 may include a first active region AR1 and a second active region AR2. Each of the first and second active regions AR1 and AR2 may extend in a second direction D2. In some implementations, the first active region AR1 may be an NMOSFET region, and the second active region AR2 may be a PMOSFET region.

A first active pattern AP1 and a second active pattern AP2 may be defined by a trench TR formed on an upper portion of the substrate 100. The first active pattern AP1 may be provided on the first active region AR1, and the second active pattern AP2 may be provided on the second active region AR2. The first and second active patterns AP1 and AP2 may extend in the second direction D2. The first and second active patterns AP1 and AP2 may be vertically protruding portions of the substrate 100.

A device isolation layer ST may be provided on the substrate 100. The device isolation layer ST may fill the trench TR. The device isolation layer ST may include a silicon oxide layer. The device isolation layer ST may not cover any of first and second channel patterns CH1 and CH2 which will be discussed below.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 that are sequentially stacked. The first, second, and third semiconductor patterns SP1, SP2, and SP3 may be spaced apart from each other in a vertical direction (or a third direction D3).

Each of the first, second, and third semiconductor patterns SP1, SP2, and SP3 may include silicon (Si), germanium (Ge), or silicon-germanium (SiGe). For example, each of the first, second, and third semiconductor patterns SP1, SP2, and SP3 may include crystalline silicon. In some implementations, the first, second, and third semiconductor patterns SP1, SP2, and SP3 may be stacked nano-sheets.

A plurality of first source/drain patterns SD1 may be provided on the first active pattern AP1. A plurality of first recesses RS 1 may be formed on an upper portion of the first active pattern AP1. The first source/drain patterns SD1 may be correspondingly provided in the first recesses RS1. The first source/drain patterns SD1 may be impurity regions of a first conductivity type (e.g., n-type). The first channel pattern CH1 may be interposed between a pair of first source/drain patterns SD1. For example, the pair of first source/drain patterns SD1 may be connected through the stacked first, second, and third semiconductor patterns SP1, SP2, and SP3. In the implementations illustrated herein, the phrase source/drain pattern may be understood to mean a source terminal pattern or a drain terminal pattern of a transistor.

A plurality of second source/drain patterns SD2 may be provided on the second active pattern AP2. A plurality of second recesses RS2 may be formed on an upper portion of the second active pattern AP2. The second source/drain patterns SD2 may be correspondingly provided in the second recesses RS2. The second source/drain patterns SD2 may be impurity regions of a second conductivity type (e.g., p-type). The second channel pattern CH2 may be interposed between a pair of second source/drain patterns SD2. For example, the pair of second source/drain patterns SD2 may be connected through the stacked first, second, and third semiconductor patterns SP1, SP2, and SP3.

The first and second source/drain patterns SD1 and SD2 may be epitaxial patterns formed by a selective epitaxial growth (SEG) process. For example, each of the first and second source/drain patterns SD1 and SD2 may have a top surface higher than that of the third semiconductor pattern SP3. For another example, at least one of the first and second source/drain patterns SD1 and SD2 may have a top surface at substantially the same level as that of a top surface of the third semiconductor pattern SP3.

In some implementations, the first source/drain patterns SD1 may include the same semiconductor element (e.g., Si) as that of the substrate 100. The second source/drain patterns SD2 may include a semiconductor element (e.g., SiGe) whose lattice constant is greater than that of a semiconductor element (e.g., Si) of the substrate 100. Therefore, a pair of second source/drain patterns SD2 may provide the second channel pattern CH2 with compressive stress.

Each of the first and second source/drain patterns SD1 and SD2 may have an uneven embossing shape at a sidewall thereof. For example, each of the first and second source/drain patterns SD1 and SD2 may have a wavy profile at its sidewall. The sidewall of each of the first and second source/drain patterns SD1 and SD2 may protrude toward first, second, and third inner gate electrodes IGE1, IGE2, and IGE3 of a gate electrode GE which will be discussed below. With reference to FIGS. 6A and 6B, the following will discuss in detail the first source/drain pattern SD1 according to the present concepts.

Gate electrodes GE may be provided on the first and second channel patterns CH1 and CH2. Etch of the gate electrodes GE may extend in a first direction D1, while running across the first and second channel patterns CH1 and CH2. Each of the gate electrodes GE may vertically overlap the first and second channel patterns CH1 and CH2. The gate electrodes GE may be arranged at a first pitch in the second direction D2.

The gate electrode GE may include a first inner gate electrode IGE1 interposed between the first semiconductor pattern SP1 and the active pattern AP1 or AP2, a second inner gate electrode IGE2 interposed between the first semiconductor pattern SP1 and the second semiconductor pattern SP2, a third inner gate electrode IGE3 interposed between the second semiconductor pattern SP2 and the third semiconductor pattern SP3, and an outer gate electrode OGE on the third semiconductor pattern SP3.

Referring to FIG. 5D, the gate electrode GE is provided on a top surface TS, a bottom surface BS, and opposite sidewalls SW of each of the first, second, and third semiconductor patterns SP1, SP2, and SP3. For example, a transistor is a three-dimensional field effect transistor (e.g., MBCFET or GAAFET) in which the gate electrode GE three-dimensionally surrounds the first and second channel patterns CH1 and CH2.

On the first active region AR1, inner spacers may be formed between the first source/drain pattern SD1 and the first, second, and third inner gate electrodes IGE1, IGE2, and IGE3 of the gate electrode GE. On the second active region AR2, inner spacers may be formed between the second source/drain pattern SD2 and the first, second, and third inner gate electrodes IGE1, IGE2, and IGE3 of the gate electrode GE. Each of the first, second, and third inner gate electrodes IGE1, IGE2, and IGE3 of the gate electrode GE may be spaced apart across the inner spacer from the first source/drain pattern SD1 or the second source/drain pattern SD2. The inner spacer may prevent a leakage current from the gate electrode GE. With reference to FIG. 6A, the following will discuss in detail the inner spacer according to the present concepts.

Referring back to FIGS. 4 and 5A to 5D, a pair of gate spacers GS are disposed on opposite sidewalls of the outer gate electrode OGE of the gate electrode GE. The gate spacers GS extend in the first direction D1 along the gate electrode GE. The gate spacers GS have their top surfaces higher than that of the gate electrode GE. The top surfaces of the gate spacers GS are coplanar with that of a first interlayer dielectric layer 110 which will be discussed below. In some implementations, the gate spacers GS include at least one selected from SiCN, SiCON, and SiN. In some implementations, the gate spacers GS include a multiple layer formed of at least two selected from SiCN, SiCON, and SiN.

Referring again to FIGS. 4 and 5A to 5D, a gate capping pattern GP is provided on the gate electrode GE. The gate capping pattern GP extends in the first direction D1 along the gate electrode GE. The gate capping pattern GP includes a material having an etch selectivity with respect to first and second interlayer dielectric layers 110 and 120 which will be discussed below. For example, the gate capping pattern GP includes at least one selected from SiON, SiCN, SiCON, and SiN.

A gate dielectric layer GI may be interposed between the gate electrode GE and the first channel pattern CH1 and between the gate electrode GE and the second channel pattern CH2. The gate dielectric layer GI may cover the top surface TS, the bottom surface BS, and the opposite sidewalls SW of each of the first, second, and third semiconductor patterns SP1, SP2, and SP3. The gate dielectric layer GI may cover a top surface of the device isolation layer ST that underlies the gate electrode GE. The gate dielectric layer GI may include an inner gate dielectric layer IIL between the first, second, and third semiconductor patterns SP1, SP2, and SP3 and the first, second, and third inner gate electrodes IGE1, IGE2, and IGE3, and may also include an outer gate dielectric layer OIL between the third semiconductor pattern SP3 and the outer gate electrode OGE.

In some implementations, the gate dielectric layer GI may include a silicon oxide layer or a silicon oxynitride layer. Referring to FIG. 6A, a high-k dielectric layer HK is interposed between the gate electrode GE and the gate dielectric layer GI. The high-k dielectric layer HK has a uniform thickness that surrounds the inner gate electrodes IGE1, IGE2, and IGE3 of the gate electrode GE. The high-k dielectric layer HK extends from bottom to lateral surfaces of the outer gate electrode OGE. For example, the gate dielectric layer GI has a stack structure on the high-k dielectric layer HK.

The high-k dielectric layer HK may include a high-k dielectric material whose dielectric constant is greater than that of a silicon oxide layer. For example, the high-k dielectric material may include at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In some implementations, the gate dielectric layer GI may have a structure in which a silicon oxide layer and the high-k dielectric layer HK are stacked. In some implementations, a semiconductor device according to the present concepts may include a negative capacitance field effect transistor that uses a negative capacitor. For example, the gate dielectric layer GI may include a ferroelectric material layer that has ferroelectric properties and a paraelectric material layer that has paraelectric properties.

The ferroelectric material layer may have a negative capacitance, and the paraelectric material layer may have a positive capacitance. For example, when two or more capacitors are connected in series, and when each capacitor has a positive capacitance, an overall capacitance may be reduced to be less than the capacitance of each capacitor. In contrast, when at least one of two or more capacitors connected in series has a negative capacitance, an overall capacitance may have a positive value that is increased to be greater than an absolute value of the capacitance of each capacitor.

When the ferroelectric material layer having a negative capacitance is connected in series to the paraelectric material layer having a positive capacitance, there may be an increase in overall capacitance of the ferroelectric and paraelectric material layers that are connected in series. The increase in overall capacitance may be used to allow a transistor including the ferroelectric material layer to have a sub-threshold swing of less than about 60 mV/decade at room temperature.

The ferroelectric material layer may have ferroelectric properties. The ferroelectric material layer may include, for example, one or more of hafnium oxide, hafnium zirconium oxide, barium strontium titanium oxide, and lead zirconium titanium oxide. For example, the hafnium zirconium oxide may be a material in which hafnium oxide is doped with zirconium (Zr). For another example, the hafnium zirconium oxide may be a compound of hafnium (Hf), zirconium (Zr), and oxygen (O).

The ferroelectric material layer may further include impurities doped therein. For example, the impurities may include at least one selected from aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of impurities included in the ferroelectric material layer may be changed depending on what ferroelectric material is included in the ferroelectric material layer.

When the ferroelectric material layer includes hafnium oxide, the ferroelectric material layer may include at least one of impurities such as gadolinium (Gd), silicon (Si), zirconium (Zr), aluminum (Al), and yttrium (Y).

When the impurities are aluminum (Al), the ferroelectric material layer may include about 3 to 8 atomic percent aluminum. In this description, the ratio of impurities may be a ratio of aluminum to the sum of hafnium and aluminum.

When the impurities are silicon (Si), the ferroelectric material layer may include about 2 to about 10 atomic percent silicon. When the impurities are yttrium (Y), the ferroelectric material layer may include about 2 to about 10 atomic percent yttrium. When the impurities are gadolinium (Gd), the ferroelectric material layer may include about 1 to about 7 atomic percent gadolinium. When the impurities are zirconium (Zr), the ferroelectric material layer may include about 50 to about 80 atomic percent zirconium.

The paraelectric material layer may have paraelectric properties. The paraelectric material layer may include, for example, at least one selected from silicon oxide and high-k metal oxide. The metal oxide included in the paraelectric material layer may include, for example, one or more of hafnium oxide, zirconium oxide, and aluminum oxide, but the present concepts are not limited thereto.

The ferroelectric and paraelectric material layers may include the same material. The ferroelectric material layer may have ferroelectric properties, but the paraelectric material layer may not have ferroelectric properties. For example, when the ferroelectric material layer and the paraelectric material layer include hafnium oxide, the hafnium oxide included in the ferroelectric material layer may have a crystal structure different from that of the hafnium oxide included in the paraelectric material layer.

The ferroelectric material layer may have a thickness having ferroelectric properties. The thickness of the ferroelectric material layer may range, for example, from about 0.5 nm to about 10 nm, but the present concepts are not limited thereto. Because ferroelectric materials have their own critical thickness that exhibits ferroelectric properties, the thickness of the ferroelectric material layer may depend on ferroelectric material.

For example, the gate dielectric layer GI may include a single ferroelectric material layer. For another example, the gate dielectric layer GI may include a plurality of ferroelectric material layers that are spaced apart from each other. The gate dielectric layer GI may have a stack structure in which a plurality of ferroelectric material layers are alternately stacked with a plurality of paraelectric material layers.

Referring back to FIGS. 4 and 5A to 5D, the gate electrode GE includes a first metal pattern and a second metal pattern on the first metal pattern. The first metal pattern is provided on the gate dielectric layer GI and is adjacent to the first, second, and third semiconductor patterns SP1, SP2, and SP3. The first metal pattern includes a work-function metal that controls a threshold voltage of a transistor. A thickness and composition of the first metal pattern are adjusted to achieve a desired threshold voltage of a transistor. For example, the first, second, and third inner gate electrodes IGE1, IGE2, and IGE3 of the gate electrode GE are formed of the first metal pattern or a work-function metal.

The first metal pattern may include a metal nitride layer. For example, the first metal pattern may include nitrogen (N) and at least one metal selected from titanium (Ti), tantalum (Ta), aluminum (Al), tungsten (W), and molybdenum (Mo). In addition, the first metal pattern may further include carbon (C). The first metal pattern may include a plurality of stacked work-function metal layers.

The second metal pattern may include metal whose resistance is less than that of the first metal pattern. For example, the second metal pattern may include at least one metal selected from tungsten (W), aluminum (Al), titanium (Ti), and tantalum (Ta). For example, the outer gate electrode OGE of the gate electrode GE may include a first metal pattern and a second metal pattern on the first metal pattern.

A first interlayer dielectric layer 110 may be provided on the substrate 100. The first interlayer dielectric layer 110 may cover the gate spacers GS and the first and second source/drain patterns SD1 and SD2. The first interlayer dielectric layer 110 may have a top surface substantially coplanar with that of the gate capping pattern GP and that of the gate spacer GS. The first interlayer dielectric layer 110 may be provided thereon with a second interlayer dielectric layer 120 that covers the gate capping pattern GP. A third interlayer dielectric layer 130 may be provided on the second interlayer dielectric layer 120. A fourth interlayer dielectric layer 140 may be provided on the third interlayer dielectric layer 130. For example, the first to fourth interlayer dielectric layers 110 to 140 may include a silicon oxide layer.

The single height cell SHC may have a first boundary BD1 and a second boundary BD2 that are opposite to each other in the second direction D2. The first and second boundaries BD1 and BD2 may extend in the first direction D1. The single height cell SHC may have a third boundary BD3 and a fourth boundary BD4 that are opposite to each other in the first direction D1. The third and fourth boundaries BD3 and BD4 may extend in the second direction D2.

The single height cell SHC may be provided on its opposite sides with a pair of separation structures DB that are opposite to each other in the second direction D2. For example, the pair of separation structures DB may be correspondingly provided on the first and second boundaries BD1 and BD2 of the single height cell SHC. The separation structure DB may extend in the first direction D1 parallel to the gate electrodes GE. A pitch between the separation structure DB and its adjacent gate electrode GE may be the same as the first pitch.

The separation structure DB may penetrate the first and second interlayer dielectric layers 110 and 120 to extend into the first and second active patterns AP1 and AP2. The separation structure DB may penetrate an upper portion of each of the first and second active patterns AP1 and AP2. The separation structure DB may electrically separate an active region of the single height cell SHC from an active region of an adjacent another cell.

Active contacts AC may be provided to penetrate the first and second interlayer dielectric layers 110 and 120 to come into electrical connection with the first and second source/drain patterns SD1 and SD2. A pair of active contacts AC may be provided on opposite sides of the gate electrode GE. When viewed in plan, the active contact AC may have a bar shape that extends in the first direction D1.

The active contact AC may be a self-aligned contact. For example, the gate capping pattern GP and the gate spacer GS may be used to form the active contact AC in a self-alignment manner. The active contact AC may cover, for example, at least a portion of a sidewall of the gate spacer GS. Although not shown, the active contact AC may cover a portion of the top surface of the gate capping pattern GP.

A metal-semiconductor compound layer SC, such as a silicide layer, may be interposed between the active contact AC and the first source/drain pattern SD1 and between the active contact AC and the second source/drain pattern SD2. The active contact AC may be electrically connected through the metal-semiconductor compound layer SC to one of the first and second source/drain patterns SD1 and SD2. For example, the metal-semiconductor compound layer SC may include at least one selected from titanium silicide, tantalum silicide, tungsten silicide, nickel silicide, and cobalt silicide.

Gate contacts GC may be provided to penetrate the second interlayer dielectric layer 120 and the gate capping pattern GP to come into electrical connection with the gate electrodes GE. When viewed in plan, the gate contacts GC may be disposed to correspondingly overlap the first active region AR1 and the second active region AR2. For example, the gate contact GC may be provided on the second active pattern AP2 (see FIG. 5B).

In some implementations, referring to FIG. 5B, the active contact AC has an upper portion adjacent to the gate contact GC, and an upper dielectric pattern UIP fills the upper portion of the active contact AC. The upper dielectric pattern UIP has a bottom surface lower than that of the gate contact GC. For example, the upper dielectric pattern UIP causes the active contact AC adjacent to the gate contact GC to have a top surface lower than the bottom surface of the gate contact GC. Therefore, it may be possible to prevent a short-circuit resulting from contact between the gate contact GC and its adjacent active contact AC.

Each of the active contact AC and the gate contact GC may include a conductive pattern FM and a barrier pattern BM that surrounds the conductive pattern FM. For example, the conductive pattern FM may include at least one metal selected from aluminum, copper, tungsten, molybdenum, and cobalt. The barrier pattern BM may cover sidewalls and a bottom surface of the conductive pattern FM. The barrier pattern BM may include a metal layer and a metal nitride layer. The metal layer may include at least one selected from titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

A first metal layer M1 may be provided in the third interlayer dielectric layer 130. For example, the first metal layer M1 may include a first power line M1_R1, a second power line M1_R2, and first wiring lines M1_I. The lines M1_R1, M1_R2, and M1_I of the first metal layer M1 may parallel extend in the second direction D2.

For example, the first and second power lines M1_R1 and M1_R2 may be respectively provided on the third and fourth boundaries BD3 and BD4 of the single height cell SHC. The first power line M1_R1 may extend in the second direction D2 along the third boundary BD3. The second power line M1_R2 may extend in the second direction D2 along the fourth boundary BD4.

The first wiring lines M1_I of the first metal layer M1 may be disposed between the first and second power lines M1_R1 and M1_R2. The first wiring lines M1_I of the first metal layer M1 may be arranged at a second pitch along the first direction D1. The second pitch may be less than the first pitch. Each of the first wiring lines M1_I may have a line-width less than that of each of the first and second power lines M1_R1 and M1_R2.

The first metal layer M1 may further include first vias VI1. The first vias VI1 may be correspondingly provided below the lines M1_R1, M1_R2, and M1_I of the first metal layer M1. The first via VI1 may electrically connect the active contact AC to a wiring line of the first metal layer M1. The first via VI1 may electrically connect the gate contact GC to a wiring line of the first metal layer M1.

A certain line, e.g., first wiring line M1_I, and its underlying first via VI1 of the first metal layer M1 may be formed by individual processes. For example, the certain line and its underlying first via VI1 of the first metal layer M1 may each be formed by a single damascene process. A sub-20 nm process may be employed to fabricate a semiconductor device according to some implementations.

A second metal layer M2 may be provided in the fourth interlayer dielectric layer 140. The second metal layer M2 may include a plurality of second wiring lines M2_I. The second wiring lines M2_I of the second metal layer M2 may each have a linear or bar shape that extends in the first direction D1. For example, the second wiring lines M2_I may be parallel and extend in the first direction D1.

The second metal layer M2 may further include second vias VI2 that are correspondingly provided below the second wiring lines M2_I. A certain line, e.g., second wiring line M2_I, of the first metal layer M1 may be electrically through the second via VI2 to a corresponding line of the second metal layer M2. For example, a wiring line and its underlying second via VI2 of the second metal layer M2 may be simultaneously formed in a dual damascene process.

The first and second metal layers M1 and M2 may have their wiring lines that include the same or different conductive materials. For example, the wiring lines of the first and second metal layers M1 and M2 may include at least one metallic material selected from aluminum, copper, tungsten, molybdenum, ruthenium, and cobalt. Although not shown, other metal layers (e.g., M3, M4, M5, etc.) may be additionally stacked on the fourth interlayer dielectric layer 140. Each of the stacked metal layers may include wiring lines for routing between cells.

FIG. 6A illustrates an example enlarged view showing section M of FIG. 5A. FIG. 6B illustrates an example enlarged view showing section N of FIG. 6A. With reference to FIG. 6A, the following will discuss in detail the gate electrode GE, the gate dielectric layer GI, an inner spacer ISP, the high-k dielectric layer HK, and the first source/drain pattern SD1. The gate electrode GE includes the first inner gate electrode IGE1, the second inner gate electrode IGE2, the third inner gate electrode IGE3, and the outer gate electrode OGE.

The gate dielectric layer GI may include a silicon oxide layer, a silicon oxynitride layer, a silicon nitride layer, or a combination thereof. The gate dielectric layer GI may include the inner gate dielectric layer IIL on each of the first, second, and third inner gate electrodes IGE1, IGE2, and IGE3, and may also include the outer gate dielectric layer OIL on the outer gate electrode OGE. The outer gate dielectric layer OIL may be provided on bottom and lateral surfaces of the outer gate electrode OGE. The outer gate dielectric layer OIL may extend to the gate capping pattern (see GP of FIG. 5A) that covers a top surface of the outer gate electrode OGE.

The inner gate dielectric layer IIL may be provided between the first, second, and third semiconductor patterns SP1, SP2, and SP3 and the first, second, and third inner gate electrodes IGE1, IGE2, and IGE3. For example, the inner gate dielectric layer IIL may surround the first, second, and third inner gate electrodes IGE1, IGE2, and IGE3.

The inner gate dielectric layer IIL may include an upper dielectric layer IILT between the first inner gate electrode IGE1 and the first semiconductor pattern SP1, a lower dielectric layer IILB between the first inner gate electrode IGE1 and the first active pattern AP1, and an inner spacer ISP between the first inner gate electrode IGE1 and the first source/drain pattern SD1.

The inner gate dielectric layer IIL may include an upper dielectric layer IILT between the second inner gate electrode IGE2 and the second semiconductor pattern SP2, a lower dielectric layer IILB between the second inner gate electrode IGE2 and the first semiconductor pattern SP1, and an inner spacer ISP between the second inner gate electrode IGE2 and the first source/drain pattern SD1.

The inner gate dielectric layer IIL may include an upper dielectric layer IILT between the third inner gate electrode IGE3 and the third semiconductor pattern SP3, a lower dielectric layer IILB between the third inner gate electrode IGE3 and the second semiconductor pattern SP2, and an inner spacer ISP between the third inner gate electrode IGE3 and the first source/drain pattern SD1.

A width WGI in the second direction D2 of the inner gate dielectric layer IIL may be less than a width WCH in the second direction D2 of each of the first, second, and third semiconductor patterns SP1, SP2, and SP3. The width WCH in the second direction D2 of each of the first, second, and third semiconductor patterns SP1, SP2, and SP3 may be the same as a width in the second direction D2 of the first channel pattern (see CH1 of FIG. 5A).

The high-k dielectric layer HK may be interposed between the inner gate dielectric layer IIL and the inner gate electrodes IGE1, IGE2, and IGE3 or between the outer gate electrode OGE and the outer gate dielectric layer OIL. The high-k dielectric layer HK may be provided on the inner gate electrodes IGE1, IGE2, and IGE3, and the inner gate dielectric layer IIL may be provided on the high-k dielectric layer HK. The high-k dielectric layer HK may be conformally formed.

Referring back to FIG. 6A, the inner spacer ISP has a first thickness TH1. The first thickness TH1 is defined to indicate a minimum distance between one lateral surface of the high-k dielectric layer HK and one lateral surface of the first source/drain pattern SD1. The first thickness TH1 is a distance in the second direction D2.

The upper dielectric layer IILT or the lower dielectric layer IILB may have a second thickness TH2. The second thickness TH2 may be defined to indicate a minimum distance between a top surface of the high-k dielectric layer HK and a bottom surface of an upper one (e.g., SP2) of neighboring semiconductor patterns (e.g., SP1 and SP2). The high-k dielectric layer HK may have a third thickness TH3. The third thickness TH3 may be defined to indicate a minimum distance between a bottom surface of the inner gate electrode (e.g., IGE2) and a top surface of a lower one (e.g., SP1) of neighboring semiconductor patterns (e.g., SP1 and SP2). The second thickness TH2 and the third thickness TH3 may each be a distance in the third direction D3.

The first thickness TH1 may be greater than the second thickness TH2. The first thickness TH1 may be greater than the third thickness TH3. The first thickness TH1 may be greater than a sum of the second thickness TH2 and the third thickness TH3. The third thickness TH3 may be greater than the second thickness TH2. Alternatively, the third thickness TH3 may be the same as the second thickness TH2. For example, the first thickness TH1 may range from about 10.0 Å to about 25.0 Å. The second thickness TH2 may range from about 5.0 Å to about 10.0 Å. The third thickness TH3 may range from about 5.0 Å to about 10.0 Å.

The first source/drain pattern SD1 may include a protrusion. The protrusion may protrude toward the first, second, and third inner gate electrodes IGE1, IGE2, and IGE3 between neighboring semiconductor patterns SP1, SP2, and SP3.

The first source/drain pattern SD1 may have an uneven embossing shape at a sidewall SSF thereof. The sidewall SSF may have a wavy profile. For example, the sidewall SSF of the first source/drain pattern SD1 may protrude toward the first, second, and third inner gate electrodes IGE1, IGE2, and IGE3 in the second direction D2, and thus may have a wavy profile. The sidewall SSF of the first source/drain pattern SD1 may include a concave part CCP and a convex part CVP. The concave part CCP and the convex part CVP may be disposed alternately with each other in the third direction D3.

The concave part CCP may be a portion where a sidewall of one of the first, second, and third semiconductor patterns SP1, SP2, and SP3 is in contact with a portion of the sidewall SSF of the first source/drain pattern SD1. The convex part CVP may be a portion where a sidewall of the inner spacer ISP is in contact with a portion of the sidewall SSF of the first source/drain pattern SD1. The convex part CVP may have a curvature less than that of the concave part CCP. Alternatively, the concave part CCP may have a curvature the same as that of the convex part CVP.

Referring to FIGS. 6A and 6B, the inner spacer ISP of the inner gate dielectric layer IIL includes a binding face BF in contact with the first source/drain pattern SD1. The second semiconductor pattern SP2 includes a binding face BF in contact with the first source/drain pattern SD1. For example, the bounding face BF is a boundary surface between the inner spacer ISP and the first source/drain pattern SD1 and between the second semiconductor pattern SP2 and the first source/drain pattern SD1.

As shown in FIG. 6B, silicon (Si) atoms in the second semiconductor pattern SP2 are arranged in a specific lattice structure (e.g., FCC). The second semiconductor pattern SP2 has a first lattice constant LC1. The first lattice constant LC1 is defined to indicate a minimum distance between atoms included in the second semiconductor pattern SP2.

Silicon (Si) atoms in the first source/drain pattern SD1 may be arranged in a specific lattice structure (e.g., FCC). The first source/drain pattern SD1 may have a second lattice constant LC2. The second lattice constant LC2 may be defined to indicate a minimum distance between atoms included in the first source/drain pattern SD1.

Silicon (Si) atoms and oxygen (O) atoms in the inner spacer ISP may be arranged in a specific lattice structure. The inner spacer ISP may have a third lattice constant LC3. The third lattice constant LC3 may be defined to indicate a minimum distance between atoms included in the inner spacer ISP.

Referring back to FIGS. 6A and 6B, silicon atoms in the first active pattern AP1 are arranged in a specific lattice structure. The first active pattern AP1 has a fourth lattice constant. The fourth lattice constant is defined to indicate a minimum distance between atoms included in the first active pattern AP1.

The second lattice constant LC2 may be the same as the first lattice constant LC1. The second lattice constant LC2 may be greater than the third lattice constant LC3. The second lattice constant LC2 may be the same as the fourth lattice constant.

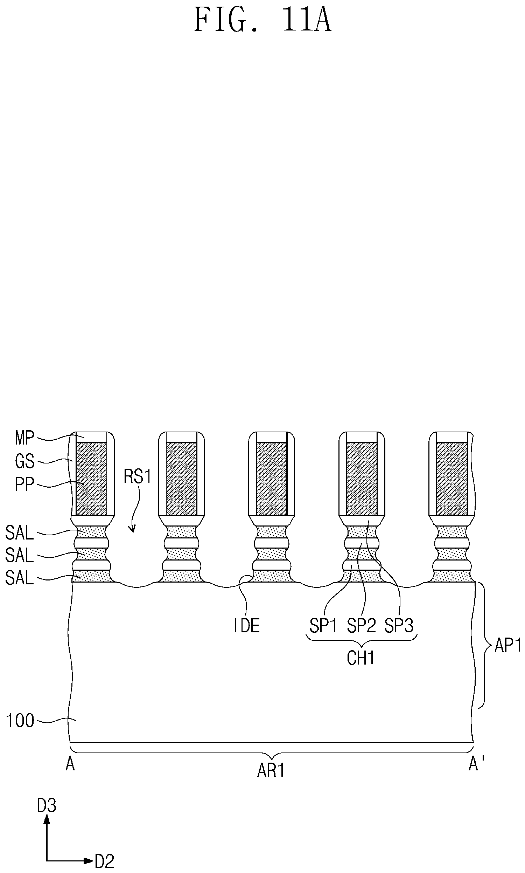

According to a subsequently described method of fabricating a semiconductor device, the first source/drain pattern SD1 may be formed ahead of the inner spacer ISP on a first recess (see RS1 of FIG. 11A) For example, the first recess RS1 may be formed to have a wavy profile, and then the first, second, and third semiconductor patterns SP1, SP2, and SP3 and the first active pattern AP1 may be used as a seed to form the first source/drain pattern SD1.

As a selective epitaxial growth (SEG) process is performed on a recessed region between the first, second, and third semiconductor patterns SP1, SP2, and SP3, the first source/drain pattern SD1 may be grown not in a polycrystalline or amorphous form, but in a single-crystalline form. This may be caused by the fact that the first source/drain pattern SD1 is formed in accordance with lattice structures of the first, second, and third semiconductor patterns SP1, SP2, and SP3 and the first active pattern AP1. For example, the first source/drain pattern SD1 may be single crystalline.

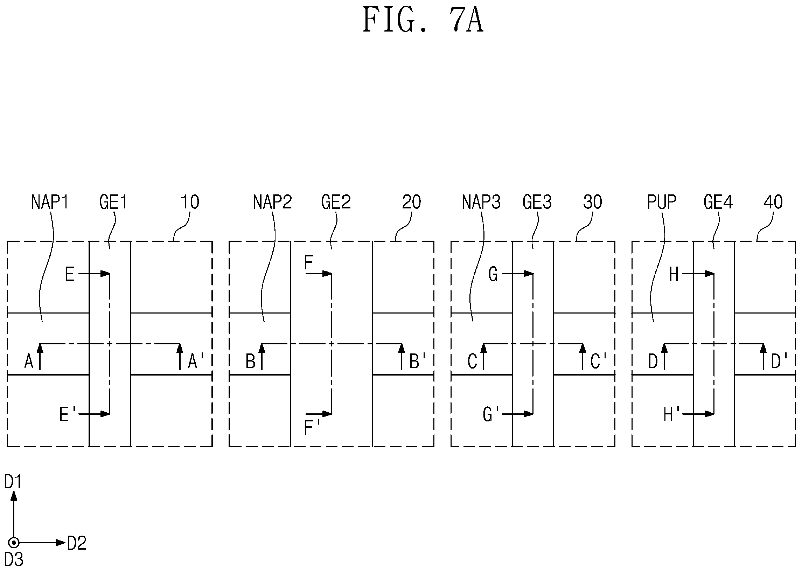

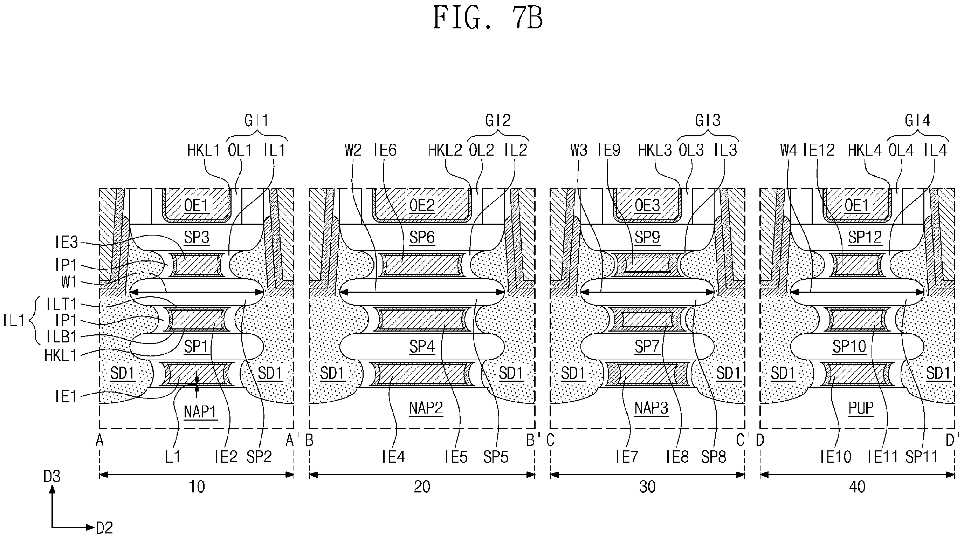

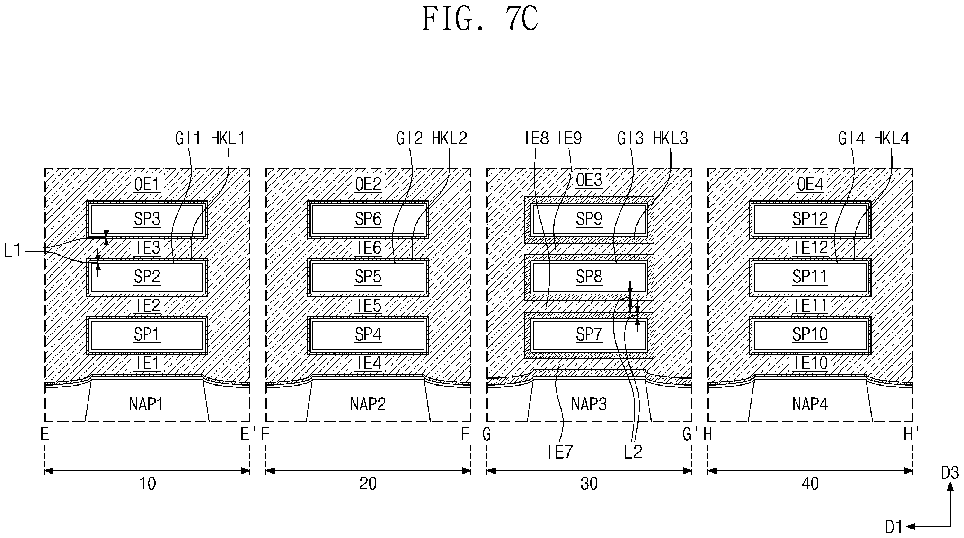

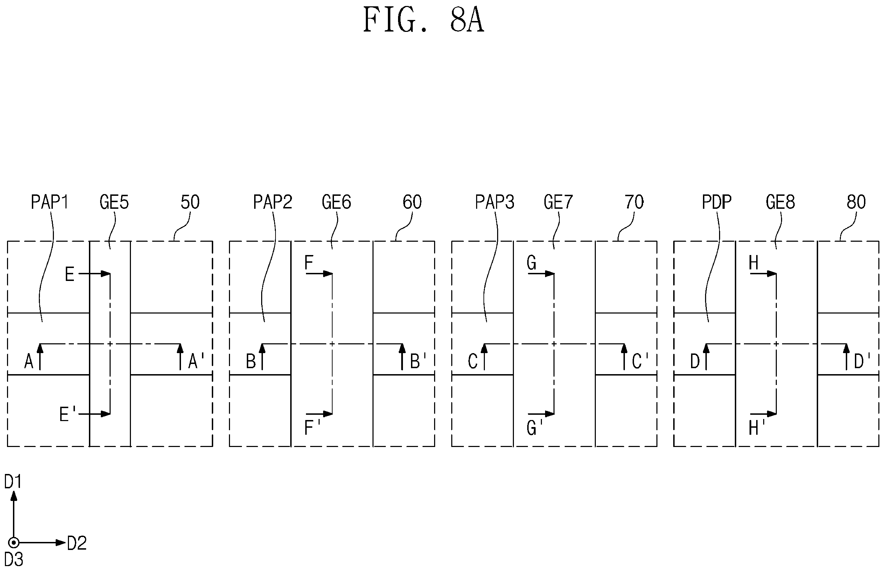

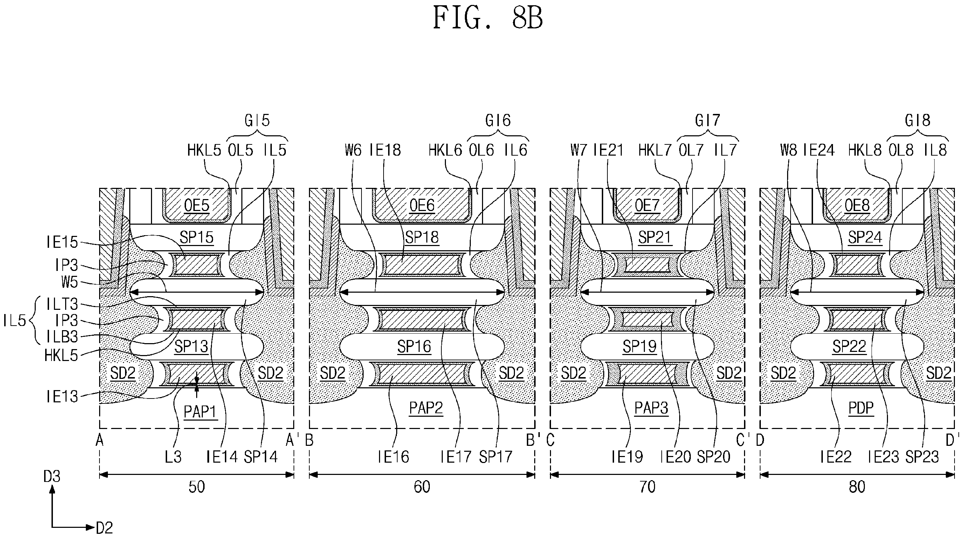

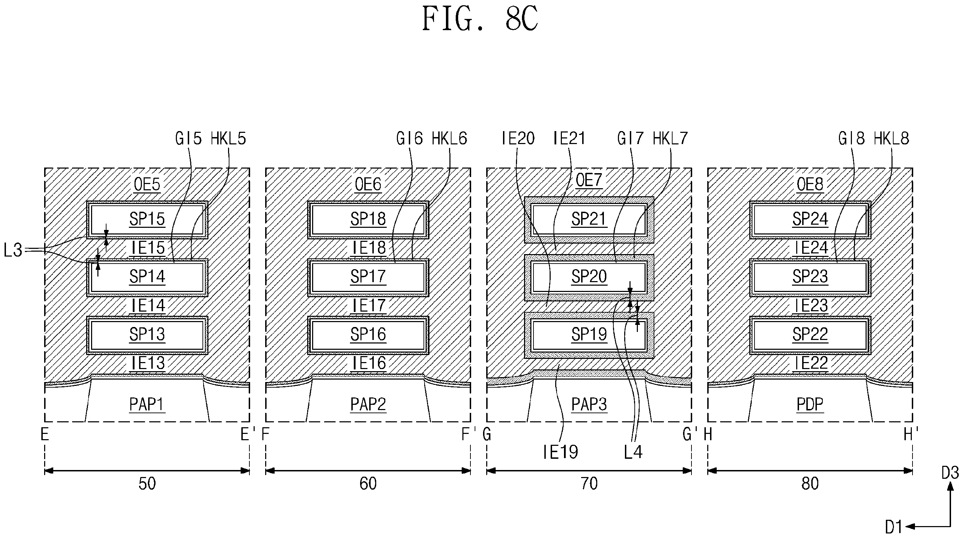

The following will describe various implementations. In the implementations that follow, a detailed description of technical features repetitive to those discussed above with reference to FIGS. 4 and 5A to 5D, 6A, and 6B will be omitted, and a difference thereof will be discussed in detail. FIGS. 7A and 8A illustrate simplified plan views partially showing an example of a semiconductor device. FIG. 7B illustrates an example cross-sectional view taken along lines A-A', B-B', C-C', and D-D' of FIG. 7A. FIG. 7C illustrates an example cross-sectional view taken along lines E-E', F-F', G-G', and H-H' of FIG. 7A. FIG. 8B illustrates an example cross-sectional view taken along lines A-A', B-B', C-C', and D-D' of FIG. 8A. FIG. 8C illustrates an example cross-sectional view taken along lines E-E', F-F', G-G', and H-H' of FIG. 8A.

Referring to FIGS. 7A to 7C, a semiconductor device includes first to fourth active patterns NAP1, NAP2, NAP3, and PUP, first to fourth semiconductor patterns, first to fourth gate electrodes GE1, GE2, GE3, and GE4, first to fourth gate dielectric layers GI1, GI2, GI3, and GI4, first to fourth high-k dielectric layers HKL1, HKL2, HKL3, and HKL4, and first source/drain patterns SD1.

A substrate may include a first region 10, a second region 20, a third region 30, and a fourth region 40. The first to fourth regions 10, 20, 30, and 40 may be NMOSFET regions. An n-type three-dimensional field effect transistor (e.g., MBCFET or GAAFET) may be provided on the first to fourth regions 10, 20, 30, and 40.

Different elements may be provided on first to fourth regions 10, 20, 30, and 40. For example, an NMOSFET region of a standard gate short channel element (SG SC) may be formed on the first region 10. An NMOSFET region of a standard gate short channel element (SG SC) may be formed on the second region 20. An NMOSFET region of a thick oxide gate element (EG) may be formed on the third region 30. An NMOSFET region of an SRAM element (SRAM) may be formed on the fourth region 40. For example, a pull-up transistor of the SRAM element (SRAM) may be formed on the fourth region 40.

The first to fourth active patterns NAP1, NAP2, NAP3, and PUP may protrude in the third direction D3 from the substrate. The first to fourth active patterns NAP1, NAP2, NAP3, and PUP may correspond to the first active pattern (see AP1 of FIG. 5A). The first to fourth semiconductor patterns may be vertically stacked and spaced apart from each other on the first to fourth active patterns NAP1, NAP2, NAP3, and PUP, respectively.

For example, the first semiconductor patterns may include a first nano-sheet SP1, a second nano-sheet SP2, and a third nano-sheet SP3. The second semiconductor patterns may include a fourth nano-sheet SP4, a fifth nano-sheet SP5, and a sixth nano-sheet SP6. The third semiconductor patterns may include a seventh nano-sheet SP7, an eighth nano-sheet SP8, and a ninth nano-sheet SP9. The fourth semiconductor patterns may include a tenth nano-sheet SP10, an eleventh nano-sheet SP11, and a twelfth nano-sheet SP12.

The first semiconductor pattern may have a first width W1. The second semiconductor pattern may have a second width W2. The third semiconductor pattern may have a third width W3. The fourth semiconductor pattern may have a fourth width W4. The first to fourth widths W1, W2, W3, and W4 may each be defined to indicate a horizontal distance in the second direction D2. The first width W1, the third width W3, and the fourth width W4 may be the same as each other. The first width W1 may be less than the second width W2. For example, the first width W1 may range from about 5 nm to about 20 nm, and the second width W2 may range from about 30 nm to about 300 nm.

The first gate electrode GE1 may include first, second, and third inner electrodes IE1, IE2, and IE3 interposed between the first semiconductor patterns, and may also include a first outer electrode OE1 on the third nano-sheet SP3. The second gate electrode GE2 may include fourth, fifth, and sixth inner electrodes IE4, IE5, and IE6 interposed between the second semiconductor patterns, and may also include a second outer electrode OE2 on the sixth nano-sheet SP6. The third gate electrode GE3 may include seventh, eighth, and ninth inner electrodes IE7, IE8, and IE9 interposed between the third semiconductor patterns, and may also include a third outer electrode OE3 on the ninth nano-sheet SP9. The fourth gate electrode GE4 may include tenth, eleventh, and twelfth inner electrodes IE10, IE11, and IE12 interposed between the fourth semiconductor patterns, and may also include a fourth outer electrode OE4 on the twelfth nano-sheet SP12.

The first high-k dielectric layer HKL1 may be provided on the first, second, and third inner electrodes IE1, IE2, and IE3, and on bottom and lateral surfaces of the first outer electrode OE1. The second high-k dielectric layer HKL2 may be provided on the fourth, fifth, and sixth inner electrodes IE4, IE5, and IE6, and on bottom and lateral surfaces of the second outer electrode OE2. The third high-k dielectric layer HKL3 may be provided on the seventh, eighth, and ninth inner electrodes IE7, IE8, and IE9, and on bottom and lateral surfaces of the third outer electrode OE3. The fourth high-k dielectric layer HKL4 may be provided on the tenth, eleventh, and twelfth inner electrodes IE10, IE11, and IE12, and on bottom and lateral surfaces of the fourth outer electrode OE4.

The first high-k dielectric layer HKL1 may have a thickness less than that of the third high-k dielectric layer HKL3. For example, the first high-k dielectric layer HKL1 may have a thickness of about 0.2 nm to about 20 nm, and the third high-k dielectric layer HKL3 may have a thickness of about 2.5 nm to about 4.5 nm.

The first, second, third, and fourth gate dielectric layers GI1, GI2, GI3, and GI4 may be respectively provided on the first, second, third, and fourth high-k dielectric layers HKL1, HKL2, HKL3, and HKL4. The first gate dielectric layer GI1 may include a first inner gate dielectric layer IL1 on the first, second, and third inner electrodes IE1, IE2, and IE3, and may also include a first outer gate dielectric layer OL1 on the first outer electrode OE1. The second gate dielectric layer GI2 may include a second inner gate dielectric layer IL2 on the fourth, fifth, and sixth inner electrodes IE4, IE5, and IE6, and may also include a second outer gate dielectric layer OL2 on the second outer electrode OE2. The third gate dielectric layer GI3 may include a third inner gate dielectric layer IL3 on the seventh, eighth, and ninth inner electrodes IE7, IE8, and IE9, and may also include a third outer gate dielectric layer OL3 on the third outer electrode OE3. The fourth gate dielectric layer GI4 may include a fourth inner gate dielectric layer IL4 on the tenth, eleventh, and twelfth inner electrodes IE10, IE11, and IE12, and may also include a fourth outer gate dielectric layer OL4 on the fourth outer electrode OE4.

For example, the first inner gate dielectric layer IL1 may include a first upper dielectric layer ILT1, a first lower dielectric layer ILB1, and a first inner spacer IP1. The first inner spacer IP1 may be disposed on a sidewall of at least one of the first, second, third, and fourth high-k dielectric layers HKL1, HKL2, HKL3, and HKL4. For example, the first inner spacer IP1 may be disposed on a sidewall of each of the first high-k dielectric layer HKL1 and the fourth high-k dielectric layer HKL4.

Referring to FIGS. 8A to 8C, a semiconductor device includes fifth to eighth active patterns PAP1, PAP2, PAP3, and PDP, fifth to eighth semiconductor patterns, fifth to eighth gate electrodes GE5, GE6, GE7, and GE8, fifth to eighth gate dielectric layers GI5, GI6, GI7, and GI8, and fifth to eighth high-k dielectric layers HKL5, HKL6, HKL7, and HKL8, and second source/drain patterns SD2.

A substrate may include a fifth region 50, a sixth region 60, a seventh region 70, and an eighth region 80. The fifth to eighth regions 50, 60, 70, and 80 may be PMOSFET regions. A p-type three-dimensional field effect transistor (e.g., MBCFET or GAAFET) may be provided on the fifth to eighth regions 50, 60, 70, and 80.

Different elements may be provided on the fifth to eighth regions 50, 60, 70, and 80. For example, a PMOSFET region of a standard gate short channel element (SG SC) may be formed on the fifth region 50. A PMOSFET region of a standard gate short channel element (SG SC) may be formed on the sixth region 60. A PMOSFET region of a thick oxide gate element (EG) may be formed on the seventh region 70. A PMOSFET region of an SRAM element (SRAM) may be formed on the eighth region 80. For example, a pass gate transistor or a pull-down transistor of the SRAM element (SRAM) may be formed on the eighth region 80.

The fifth to eighth active patterns PAP1, PAP2, PAP3, and PDP may protrude in the third direction D3 from the substrate. The fifth to eighth active patterns PAP1, PAP2, PAP3, and PDP may correspond to the second active pattern (see AP2 of FIG. 5B). The fifth to eighth semiconductor patterns may be vertically stacked and spaced apart from each other on the fifth to eighth patterns PAP1, PAP2, PAP3, and PDP, respectively.

For example, the fifth semiconductor patterns may include a thirteenth nano-sheet SP13, a fourteenth nano-sheet SP14, and a fifteenth nano-sheet SP15. The sixth semiconductor patterns may include a sixteenth nano-sheet SP16, a seventeenth nano-sheet SP17, and an eighteenth nano-sheet SP18. The seventh semiconductor pattern may include a nineteenth nano-sheet SP19, a twentieth nano-sheet SP20, and a twenty-first nano-sheet SP21. The eighth semiconductor pattern may include a twenty-second nano-sheet SP22, a twenty-third nano-sheet SP23, and a twenty-fourth nano-sheet SP24.

The fifth semiconductor pattern may have a fifth width W5. The sixth semiconductor pattern may have a sixth width W6. The seventh semiconductor pattern may have a seventh width W7. The eighth semiconductor pattern may have an eighth width W8. The fifth to eighth widths W5, W6, W7, and W8 may each be defined to indicate a horizontal distance in the second direction D2. The fifth, seventh, and eighth widths W5, W7, and W8 may be substantially the same as each other. The fifth width W5 may be less than the sixth width W6. For example, the fifth width W5 may range from about 5 nm to about 20 nm, and the sixth width W6 may range from about 30 nm to about 300 nm.

The fifth gate electrode GE5 may include thirteenth, fourteenth, and fifteenth inner electrodes IE13, IE14, and IE15 interposed between the fifth semiconductor patterns, and may also include a fifth outer electrode OE5 on the fifteenth nano-sheet SP15. The sixth gate electrode GE6 may include sixteenth, seventeenth, and eighteenth inner electrodes IE16, IE17, and IE18 interposed between the sixth semiconductor patterns, and may also include a sixth outer electrode OE6 on the eighteenth nano-sheet SP18. The seventh gate electrode GE7 may include nineteenth, twentieth, and twenty-first inner electrodes IE19, IE20, and IE21 interposed between the seventh semiconductor patterns, and may also include a seventh outer electrode OE7 on the twenty-first nano-sheet SP21. The eighth gate electrode GE8 may include twenty-second, twenty-third, and twenty-fourth inner electrodes IE22, IE23, and IE24 interposed between the eighth semiconductor patterns, and may also include an eighth outer electrode OE8 on the twenty-fourth nano-sheet SP24.

The fifth high-k dielectric layer HKL5 may be provided on the thirteenth, fourteenth, and fifteenth inner electrodes IE13, IE14, and IE15, and on bottom and lateral surfaces of the fifth outer electrode OE5. The sixth high-k dielectric layer HKL6 may be provided on the sixteenth, seventeenth, and eighteenth inner electrodes IE16, IE17, and IE18, and on bottom and lateral surfaces of the sixth outer electrode OE6. The seventh high-k dielectric layer HKL7 may be provided on the nineteenth, twentieth, and twenty-first inner electrodes IE19, IE20, and IE21, and on bottom and lateral surfaces of the seventh outer electrode OE7. The eighth high-k dielectric layer HKL8 may be provided on the twenty-second, twenty-third, and twenty-fourth inner electrodes IE22, IE23, and IE24, and on bottom and lateral surfaces of the eighth outer electrode OE8.

The fifth high-k dielectric layer HKL5 may have a thickness less than that of the seventh high-k dielectric layer HKL7. For example, the fifth high-k dielectric layer HKL5 may have a thickness of about 0.2 nm to about 20 nm, and the seventh high-k dielectric layer HKL7 may have a thickness of about 2.5 nm to about 4.5 nm.

The fifth to eighth gate dielectric layers GI5, GI6, GI7, and GI8 may be provided in the fifth to eighth high-k dielectric layers HKL5, HKL6, HKL7, and HKL8, respectively. The fifth gate dielectric layer GI5 may include a fifth inner gate dielectric layer IL5 on the thirteenth, fourteenth, and fifteenth inner electrodes IE13, IE14, and IE15, and may also include a fifth outer gate dielectric layer OL5 on the fifth outer electrode OE5. The sixth gate dielectric layer GI6 may include a sixth inner gate dielectric layer IL6 on the sixteenth, seventeenth, and eighteenth inner electrodes IE16, IE17, and IE18, and may also include a sixth outer gate dielectric layer OL6 on the sixth outer electrode OE6. The seventh gate dielectric layer GI7 may include a seventh inner gate dielectric layer IL7 on the nineteenth, twentieth, and twenty-first inner electrodes IE19, IE20, and IE21, and may also include a seventh outer gate dielectric layer OL7 on the seventh outer electrode OE7. The eighth gate dielectric layer GI8 may include an eighth inner gate dielectric layer IL8 on the twenty-second, twenty-third, and twenty-fourth inner electrodes IE22, IE23, and IE24, and may also include an eighth outer gate dielectric layer OL8 on the eighth outer electrode OE8.

For example, the fifth inner gate dielectric layer IL5 may include a second upper dielectric layer ILT3, a second lower dielectric layer ILB3, and a second inner spacer IP3. The second inner spacer IP3 may be disposed on a sidewall of at least one of the fifth, sixth, seventh, and eighth high-k dielectric layers HKL5, HKL6, HKL7, and HKL8. For example, the second inner spacer IP3 may be disposed on a sidewall of each of the fifth high-k dielectric layer HKL5 and the eighth high-k dielectric layer HKL8.

The first to eight high-k dielectric layers HKL1 to HKL8 may include, for example, at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

With reference to Tables 1 and 2 below, the following will describe a semiconductor device according to some implementations. Table 1 lists the presence or absence of an inner spacer on an NMOSFET region in each of a standard gate short channel element (SG SC), a standard gate long channel element (SG LC), a thick oxide gate element (EG), and an SRAM element (SRAM). Table 2 lists the presence or absence of an inner spacer on a PMOSFET region in each of a standard gate short channel element (SG SC), a standard gate long channel element (SG LC), a thick oxide gate element (EG), and an SRAM element (SRAM).

For example, on an NMOSFET region of Table 1, an SRAM element (SRAM) may be a pull-up transistor, and on a PMOSFET region of Table 2, an SRAM element (SRAM) may be a pull-down transistor or a pass gate transistor. In Tables 1 and 2, symbol "∘" may mean that an inner spacer is formed, and symbol "X" may mean that an inner spacer is not formed.

**[Table 1]**

| | NMOSFET | | | |
|---|---|---|---|---|
| Implementation | SG SC | SG LC | EG | SRAM |
| 1 | ○ | × | × | × |
| 2 | × | ○ | × | × |
| 3 | × | × | ○ | × |
| 4 | × | × | × | ○ |
| 5 | ○ | ○ | × | × |
| 6 | ○ | × | ○ | × |
| 7 | ○ | × | × | ○ |
| 8 | × | ○ | ○ | × |
| 9 | × | ○ | × | ○ |
| 10 | × | × | ○ | ○ |
| 11 | ○ | ○ | ○ | × |
| 12 | ○ | ○ | × | ○ |
| 13 | ○ | × | ○ | ○ |
| 14 | × | ○ | ○ | ○ |
| 15 | ○ | ○ | ○ | ○ |
| 16 | × | × | × | × |

**[Table 2]**

| | PMOSFET | | | |
|---|---|---|---|---|
| Implementation | SG SC | SG LC | EG | SRAM |
| 17 | ○ | × | × | × |
| 18 | × | ○ | × | × |
| 19 | × | × | ○ | × |
| 20 | × | × | × | ○ |
| 21 | ○ | ○ | × | × |
| 22 | ○ | × | ○ | × |
| 23 | ○ | × | × | ○ |
| 24 | × | ○ | ○ | × |
| 25 | × | ○ | × | ○ |
| 26 | × | × | ○ | ○ |
| 27 | ○ | ○ | ○ | × |
| 28 | ○ | ○ | × | ○ |
| 29 | ○ | × | ○ | ○ |
| 30 | × | ○ | ○ | ○ |
| 31 | ○ | ○ | ○ | ○ |
| 32 | × | × | × | × |

On an NMOSFET region and a PMOSFET region, an inner spacer may be formed or not for each element by combining Implementations of Table 1 with Implementations of Table 2. For example, the implementation of the FIGS. 7A to 7C and 8A to 8C may be a combination of Implementation 7 of Table 1 and Implementation 23 of Table 2.

In each of a plurality of elements, the absence or absence of an inner spacer may be implemented to effectively control capacitance of each of the plurality of elements. For example, based on the absence or absence of inner spacers in a plurality of elements, a target value of capacitance may be set for each element. Therefore, according to some implementations, an operation of a semiconductor device may be optimized, and a semiconductor device may increase in electrical properties.

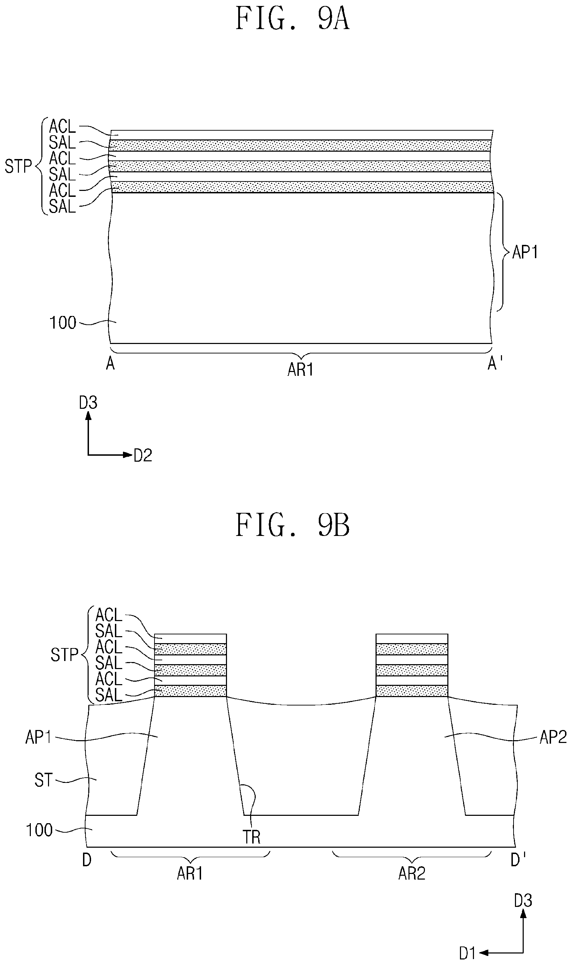

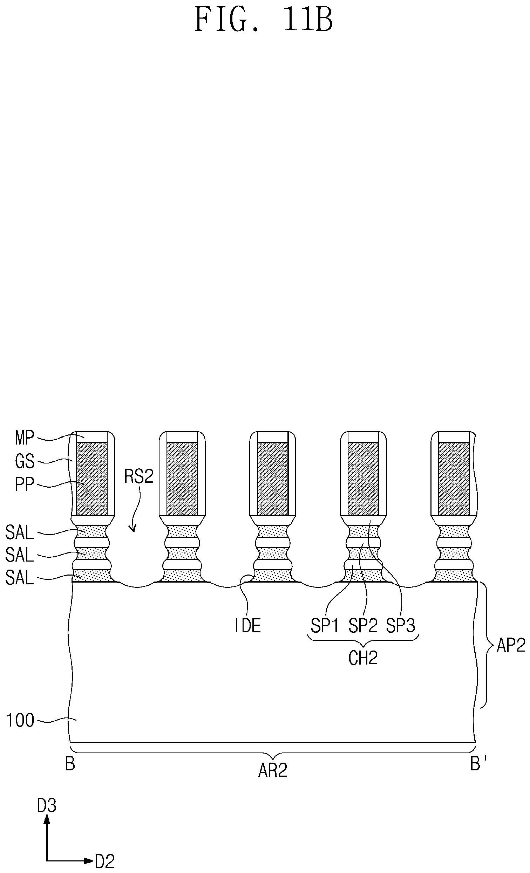

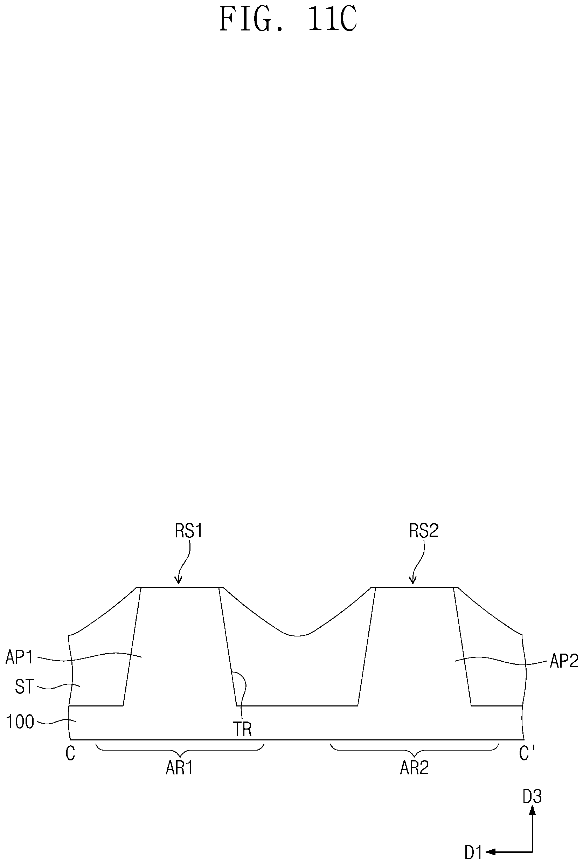

FIGS. 9A to 14D illustrate cross-sectional views showing an example of a method of fabricating a semiconductor device. In detail, FIGS. 9A, 10A, 11A, 12A, 13A, and 14A illustrate cross-sectional views taken along line A-A' of FIG. 4. FIGS. 11B, 12B, 13B, and 14B illustrate cross-sectional views taken along line B-B' of FIG. 4. FIGS. 11C, 12C, 13C, and 14C illustrate cross-sectional views taken along line C-C' of FIG. 4C. FIGS. 9B, 10B, 13D, and 14D illustrate cross-sectional views taken along line D-D' of FIG. 4.

Referring to FIGS. 9A and 9B, a substrate 100 is provided which includes a first active region AR1 and a second active region AR2. Active layers ACL and sacrificial layers SAL are alternately formed on the substrate 100. The active layers ACL include one of silicon (Si), germanium (Ge), and silicon-germanium (SiGe), and the sacrificial layers SAL may include another of silicon (Si), germanium (Ge), and silicon-germanium (SiGe).

The sacrificial layer SAL may include a material having an etch selectivity with respect to the active layer ACL. For example, the active layers ACL may include silicon (Si), and the sacrificial layers SAL may include silicon-germanium (SiGe). Each of the sacrificial layers SAL may have a germanium concentration of about 10 at% to about 30 at%.

Mask patterns may be formed on each of the first and second active regions AR1 and AR2 of the substrate 100. The mask pattern may have a linear or bar shape that extends in a second direction D2.

A patterning process may be performed in which the mask patterns are used as an etching mask to form a trench TR that defines a first active pattern AP1 and a second active pattern AP2. The first active pattern AP1 may be formed on the first active region AR1. The second active pattern AP2 may be formed on the second active region AR2.

A stack pattern STP may be formed on each of the first and second active patterns AP1 and AP2. The stack pattern STP may include the active layers ACL and the sacrificial layers SAL that are alternately stacked. During the patterning process, the stack pattern STP may be formed together with the first and second active patterns AP 1 and AP2.

A device isolation layer ST may be formed to fill the trench TR. For example, a dielectric layer may be formed on a front surface of the substrate 100 to cover the stack patterns STP and the first and second active patterns AP1 and AP2. The dielectric layer may be recessed until the stack patterns STP are exposed, and thus the device isolation layer ST may be formed.

The device isolation layer ST may include a dielectric material, such as a silicon oxide layer. The stack patterns STP may be exposed upwardly from the device isolation layer ST. For example, the stack patterns STP may vertically protrude upwards from the device isolation layer ST.

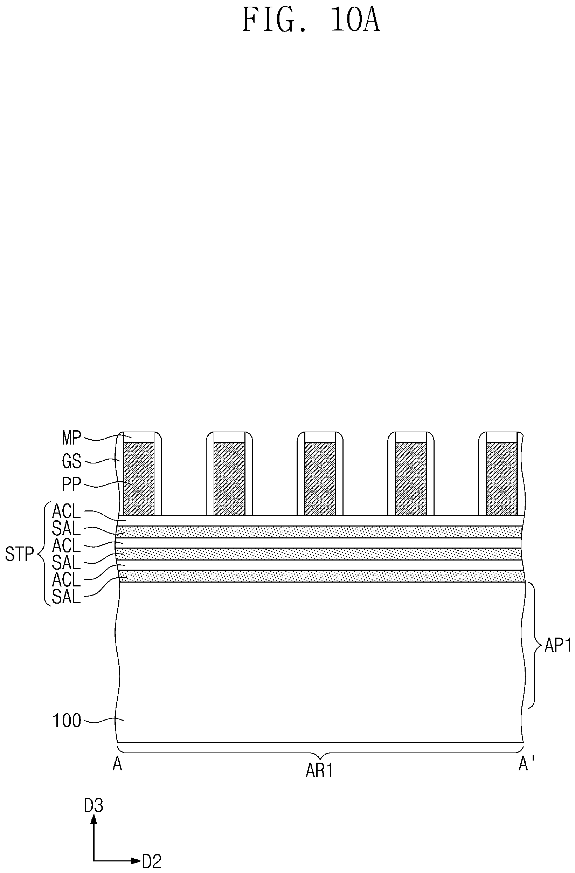

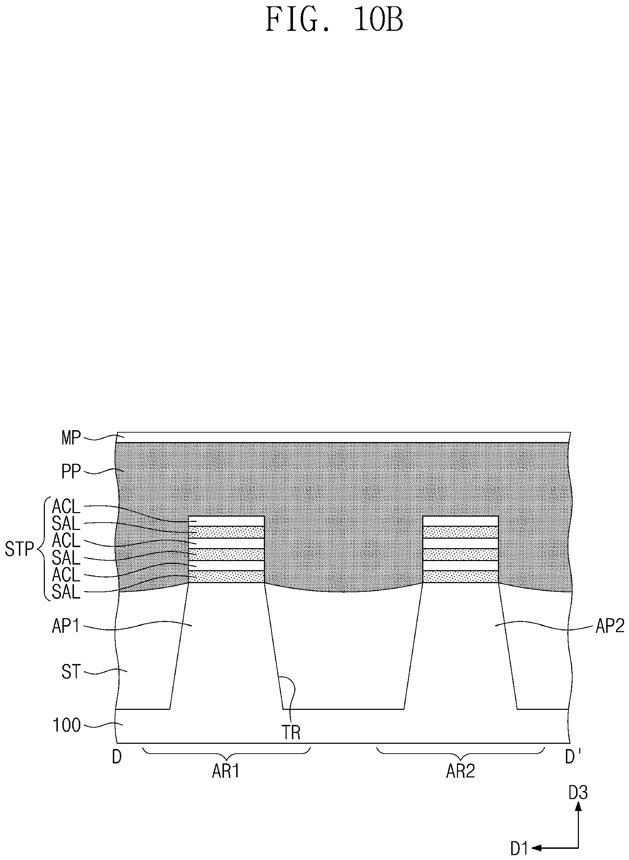

Referring to FIGS. 10A and 10B, sacrificial patterns PP are formed on the substrate 100 to run across the stack patterns STP. Each of the sacrificial patterns PP is formed to have a linear or bar shape that extends in a first direction D1. The sacrificial patterns PP are arranged at a first pitch along the second direction D2.

For example, the formation of the sacrificial patterns PP may include forming a sacrificial layer on the front surface of the substrate 100, forming hardmask patterns MP on the sacrificial layer, and using the hardmask patterns MP as an etching mask to pattern the sacrificial layer. The sacrificial layer may include polysilicon.

A pair of gate spacers GS may be formed on opposite sidewalls of each of the sacrificial patterns PP. The formation of the gate spacers GS may include conformally forming a gate spacer layer on the front surface of the substrate 100 and anisotropically etching the gate spacer layer. In some implementations, the gate spacer GS may be a multiple layer including at least two layers.

Referring to FIGS. 11A to 11C, first recesses RS1 are formed in the stack pattern STP on the first active pattern AP1. Second recesses RS2 are formed in the stack pattern STP on the second active pattern AP2. During the formation of the first and second recesses RS1 and RS2, the device isolation layer ST is further recessed on opposite sides of each of the first and second active patterns AP1 and AP2 (see FIG. 11C).

For example, the hardmask patterns MP and the gate spacers GS may be used as an etching mask such that the stack pattern STP on the first active pattern AP1 may be etched to form the first recesses RS1. The first recess RS1 may be formed between a pair of sacrificial patterns PP. The sacrificial layers SAL exposed by the first recess RS1 may undergo a selective etching process to form indent regions IDE on the first active pattern AP1. The indent regions IDE may cause the first recess RS 1 to have a wavy inner sidewall.

The active layers ACL may be formed into first, second, and third semiconductor patterns SP1, SP2, and SP3 that are sequentially stacked between neighboring first recesses RS1. A first channel pattern CH1 may be constituted by the first, second, and third semiconductor patterns SP1, SP2, and SP3 between neighboring first recesses RS1.

Referring back to FIGS. 11A to 11C, the second recesses RS2 in the stack pattern STP on the second active pattern AP2 are formed by a method similar to that used for forming the first recesses RS 1. The sacrificial layers SAL exposed by the second recess RS2 undergo a selective etching process to also form indent regions IDE on the second active pattern AP2. The indent regions IDE cause the second recess RS2 to have a wavy inner sidewall. A second channel pattern CH2 is constituted by the first, second, and third semiconductor patterns SP1, SP2, and SP3 between neighboring second recesses RS2.

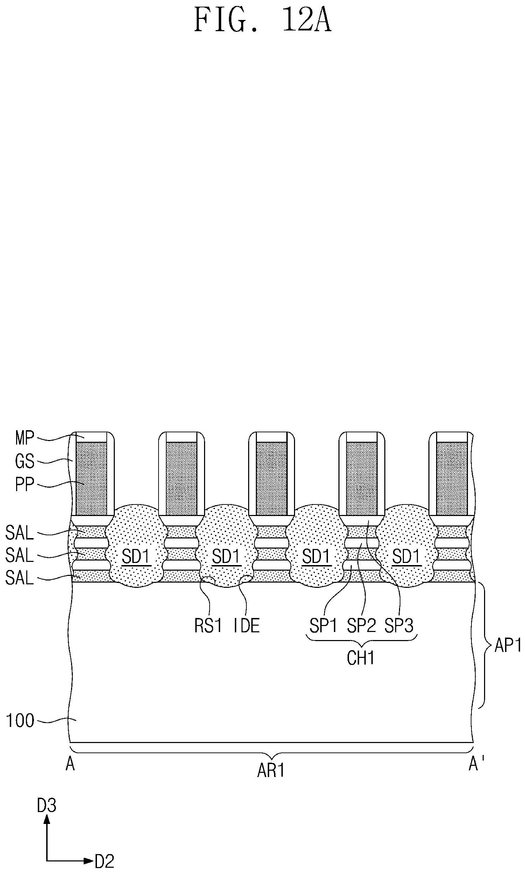

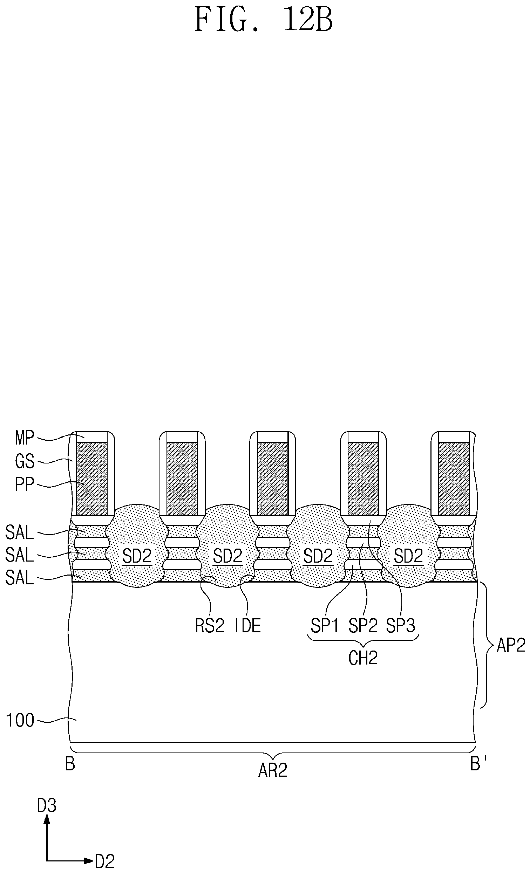

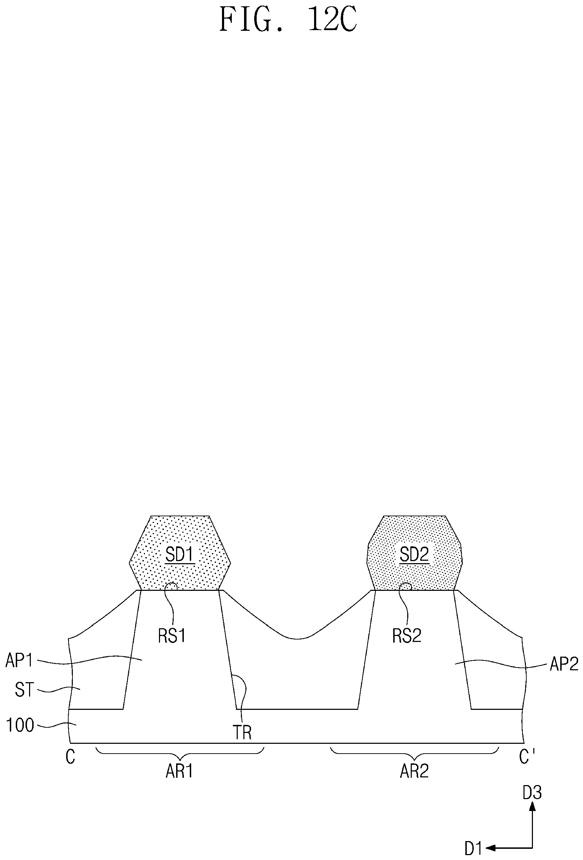

Referring to FIGS. 12A to 12C, first source/drain patterns SD1 are correspondingly formed in the first recesses RS 1. For example, a selective epitaxial growth (SEG) process is performed in which the inner sidewall of the first recess RS 1 is used as a seed layer to form an epitaxial layer that fills the first recess RS1. The epitaxial layer is grown from a seed or the substrate 100 and the first, second, and third semiconductor patterns SP1, SP1, and SP3 exposed by the first recess RS 1. For example, the SEG process includes chemical vapor deposition (CVD) or molecular beam epitaxy (MBE).

In some implementations, the first source/drain pattern SD1 may include the same semiconductor element (e.g., Si) as that of the substrate 100. While the first source/drain pattern SD1 is formed, impurities (e.g., phosphorus, arsenic, or antimony) may be in-situ implanted to allow the first source/drain pattern SD1 to have an n-type conductivity. Alternatively, after the formation of the first source/drain pattern SD1, impurities may be implanted into the first source/drain pattern SD1.

Second source/drain patterns SD2 may be correspondingly formed in the second recesses RS2. For example, a selective epitaxial growth (SEG) process may be performed such that the inner sidewall of the second recess RS2 is used as a seed to form the second source/drain pattern SD2.

In some implementations, the second source/drain pattern SD2 may include a semiconductor element (e.g., SiGe) whose lattice constant is greater than that of a semiconductor element of the substrate 100. While the second source/drain pattern SD2 is formed, impurities (e.g., boron, gallium, or indium) may be in-situ implanted to allow the second source/drain pattern SD2 to have a p-type conductivity. Alternatively, after the formation of the second source/drain pattern SD2, impurities may be implanted into the second source/drain pattern SD2.

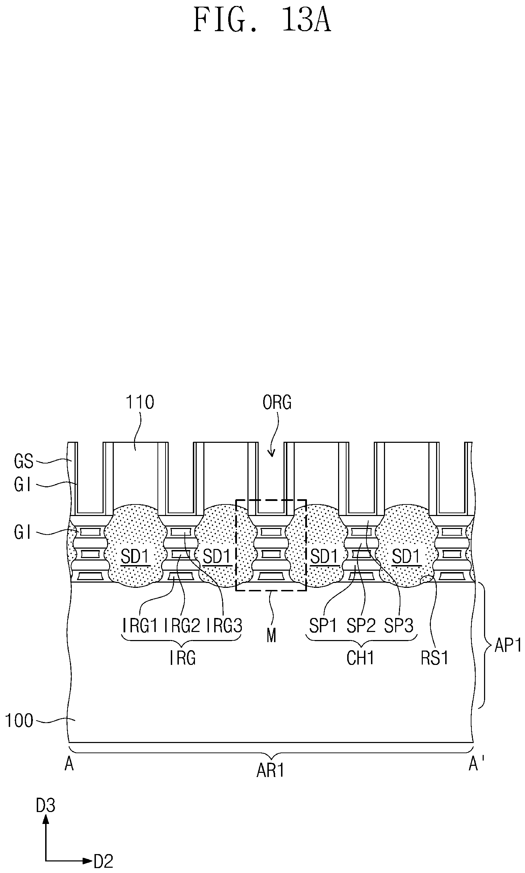

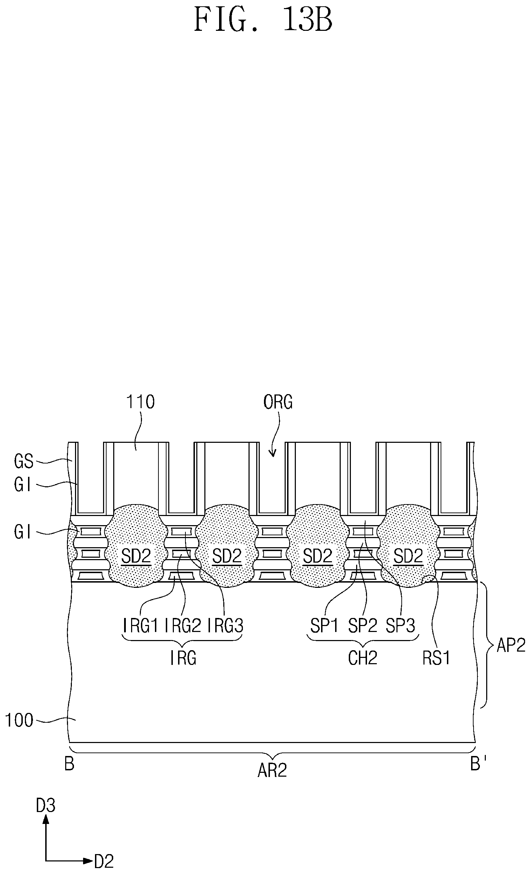

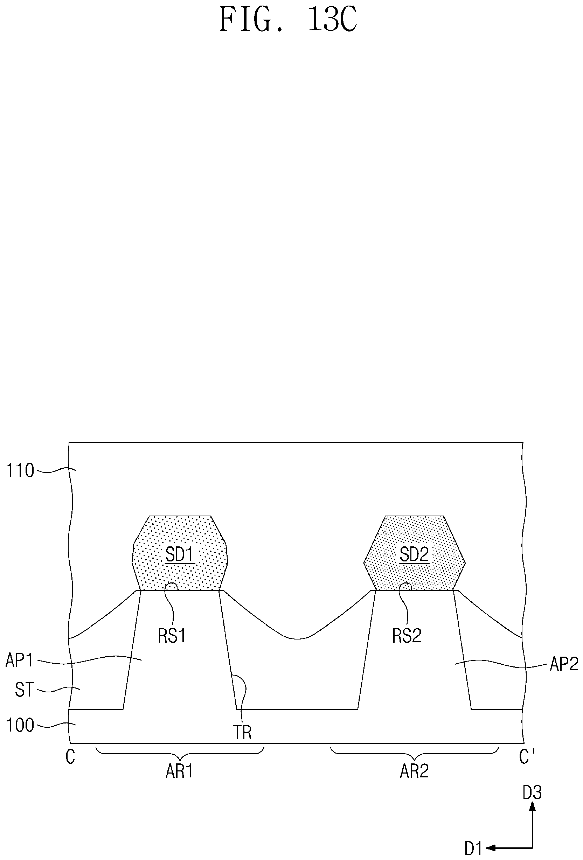

Referring to FIGS. 13A to 13D, a first interlayer dielectric layer 110 is formed to cover the first and second source/drain patterns SD1 and SD2, the hardmask patterns MP, and the gate spacers GS. For example, the first interlayer dielectric layer 110 includes a silicon oxide layer.

The first interlayer dielectric layer 110 may be planarized until top surfaces of the sacrificial patterns PP are exposed. An etch-back or chemical mechanical polishing (CMP) process may be used to planarize the first interlayer dielectric layer 110. The hardmask patterns MP may all be removed during the planarization process. As a result, the first interlayer dielectric layer 110 may have a top surface coplanar with those of the sacrificial patterns PP and those of the gate spacers GS.

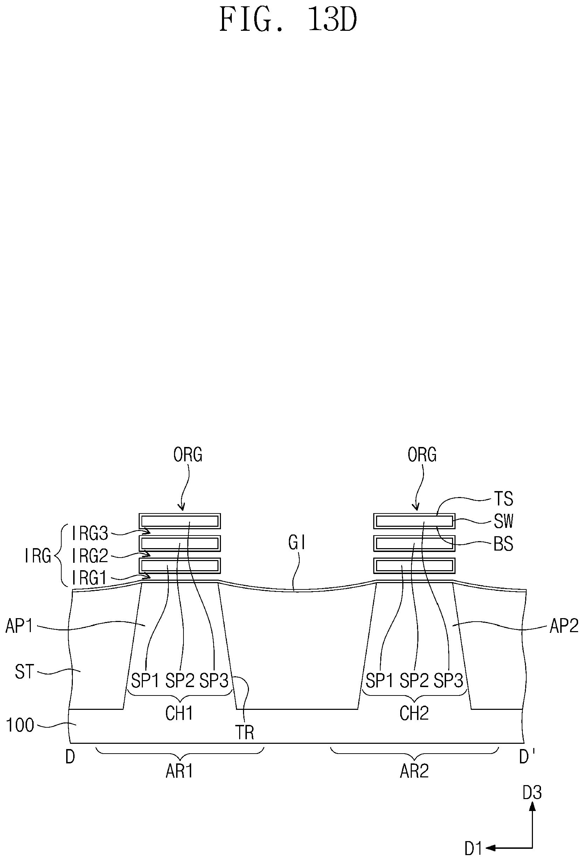

The exposed sacrificial patterns PP may be selectively removed. The removal of the sacrificial patterns PP may form an outer region ORG that exposes the first and second channel patterns CH1 and CH2 (see FIG. 13D). The removal of the sacrificial patterns PP may include performing a wet etching process using an etchant that selectively etches polysilicon.

The sacrificial layers SAL exposed through the outer region ORG may be selectively removed to form inner regions IRG (see FIG. 13D). For example, an etching process that selectively etches the sacrificial layers SAL may be performed such that only the sacrificial layers SAL may be removed while leaving the first, second, and third semiconductor patterns SP1, SP2, and SP3. The etching process may have a high etch rate with respect to silicon-germanium having a relatively high germanium concentration. For example, the etching process may have a high etch rate with respect to silicon-germanium whose germanium concentration is greater than about 10 at%.

The etching process may remove the sacrificial layers SAL on the first and second active regions AR1 and AR2. The etching process may be a wet etching process. An etching material used for the etching process may promptly etch the sacrificial layer SAL whose germanium concentrate is relatively high.

Referring back to FIG. 13D, a first inner region IRG1 is formed between the first semiconductor pattern SP1 and one of the first and second active patterns AP1 and AP2, a second inner region IRG2 is formed between the first semiconductor pattern SP1 and the second semiconductor pattern SP2, and a third inner region IRG3 is formed between the second semiconductor pattern SP2 and the third semiconductor pattern SP3.

Referring back to FIGS. 13A to 13D, a gate dielectric layer GI is formed on the exposed first, second, and third semiconductor patterns SP1, SP2, and SP3. The gate dielectric layer GI is formed to surround each of the first, second, and third semiconductor patterns SP1, SP2, and SP3. The gate dielectric layer GI is formed in each of the first, second, and third inner regions IRG1, IRG2, and IRG3. The gate dielectric layer GI is formed in the outer region ORG.

For example, the gate dielectric layer GI formed in each of the first, second, and third inner regions IRG1, IRG2, and IRG3 may correspond to the inner gate dielectric layer (see IIL of FIG. 6A). The gate dielectric layer GI formed in the outer region ORG may correspond to the outer gate dielectric layer (see OIL of FIG. 6A).

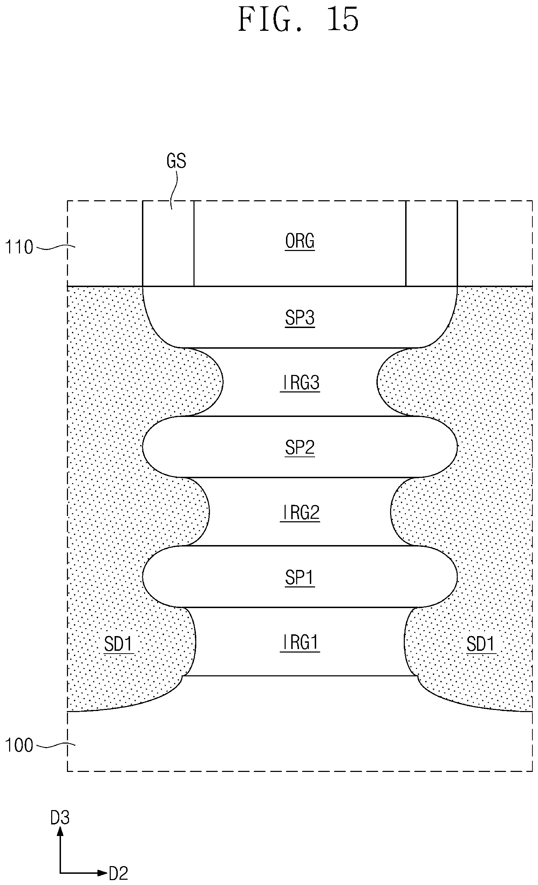

FIGS. 15 to 18 illustrate enlarged views showing an example of a method of forming section M of FIG. 13A. Referring to FIG. 15, a selective wet etching process is performed through the outer region ORG formed between the gate spacers GS, thereby removing the sacrificial layers SAL.

The first inner region IRG1 may be formed between the substrate 100 and the first semiconductor pattern SP1. The second inner region IRG2 may be formed between the first semiconductor pattern SP1 and the second semiconductor pattern SP2. The third inner region IRG3 may be formed between the second semiconductor pattern SP2 and the third semiconductor pattern SP3. The first, second, and third inner regions IRG1, IRG2, and IRG3 may each have a width in the second direction D2 less than a width in the second direction D2 of each of the first, second, and third semiconductor patterns SP1, SP2, and SP3. The outer region ORG may have a width in the second direction D2 less than a width in the second direction D2 of each of the first, second, and third semiconductor patterns SP1, SP2, and SP3.

A portion of the first source/drain pattern SD1 may protrude toward each of the first, second, and third inner regions IRG1, IRG2, and IRG3. For example, a portion of the first source/drain patterns SD1 may protrude between the substrate 100 and the first semiconductor pattern SP1, between the first semiconductor pattern SP1 and the second semiconductor pattern SP2, and between the second semiconductor pattern SP2 and the third semiconductor pattern SP3. The first, second, and third inner regions IRG1, IRG2, and IRG3 may each have a concave part at a lateral surface thereof. For example, the lateral surface of each of the first, second, and third inner regions IRG1, IRG2, and IRG3 may have a curved surface having a concave curvature.

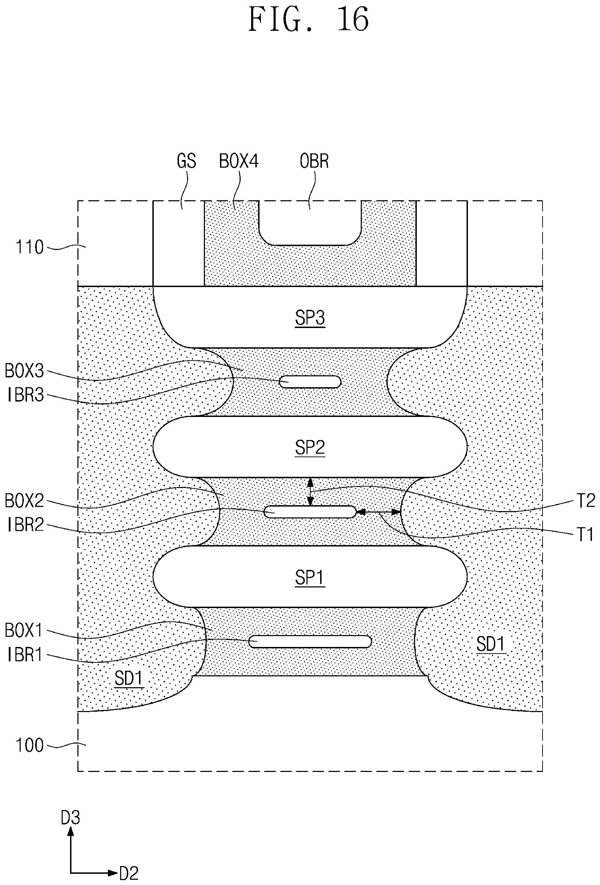

Referring to FIG. 16, a bulk silicon oxide layer is formed in the first, second, and third inner regions IRG1, IRG2, and IRG3 and the outer region ORG. The bulk silicon oxide layer is formed on the first, second, and third semiconductor patterns SP1, SP2, and SP3. The bulk silicon oxide layer includes a first bulk layer BOX1, a second bulk layer BOX2, a third bulk layer BOX3, and a fourth bulk layer BOX4. The first to fourth bulk layers BOX1 to BOX4 are formed by performing an atomic layer deposition (ALD) process. The first to fourth bulk layers BOX1 to BOX4 include silicon oxide, silicon oxynitride, silicon nitride, silicon carbonitride, or a combination thereof. For example, the first to fourth bulk layers BOX1 to BOX4 are a silicon oxide (SiOx) layer.

The first bulk layer BOX1 may be formed in the first inner region IRG1, and the second bulk layer BOX2 may be formed in the second inner region IRG2. The third bulk layer BOX3 may be formed in the third inner region IRG3, and the fourth bulk layer BOX4 may be formed on the outer region ORG.

Each of the first to fourth bulk layers BOX1 to BOX4 may be conformally formed having a uniform thickness. Thus, the first bulk layer BOX1, the second bulk layer BOX2, the third bulk layer BOX3, and the fourth bulk layer BOX4 may respectively include a first seam region IBR1, a second seam region IBR2, a third seam region IBR3, and a fourth seam region OBR.

For example, the second bulk layer BOX2 may be conformally formed in the second inner region IRG2, and may include the second seam region IBR2. The second bulk layer BOX2 may have a first length T1 in the second direction D2 and a second length T2 in the third direction D3. The first length T1 may be defined to indicate a minimum distance between a sidewall of the first source/drain pattern SD1 and a lateral surface of the second seam region IBR2. The second length T2 may be defined to indicate a minimum distance between a top surface of the second seam region IBR2 and a bottom surface of the second semiconductor pattern SP2. The first length T1 and the second length T2 may be the same as each other.

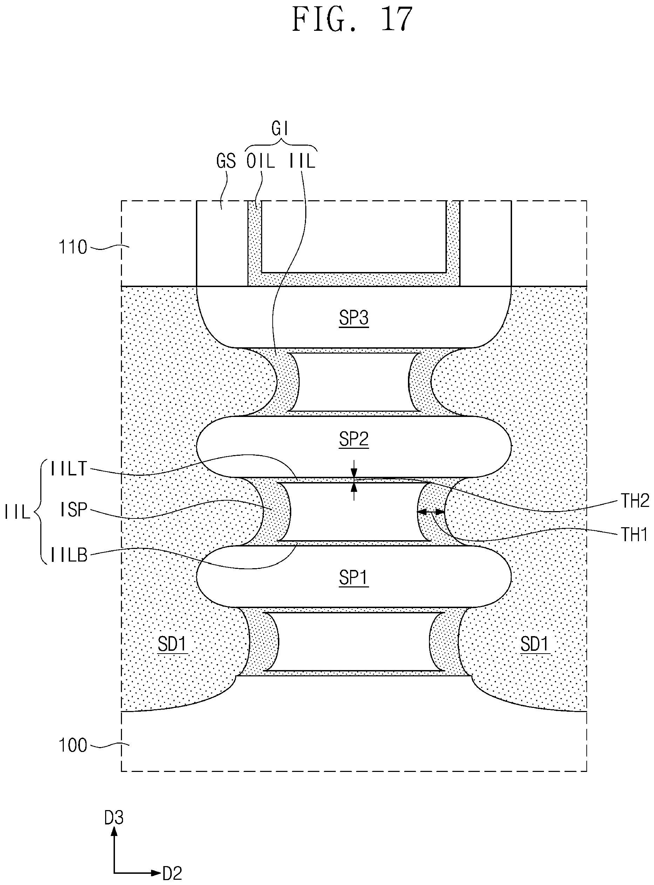

Referring to FIG. 17, an etching process is performed on the first to fourth bulk layers BOX1 to BOX4. The etching process is a composite process in which a dry etching process and a wet etching process are combined with each other. For example, the etching process is performed in such a way that a dry etching process is executed at a specific condition, and then a wet etching process is fulfilled. Thus, the etching process partially removes the bulk silicon oxide layer, or the first to fourth bulk layers BOX1 to BOX4.

For example, the first, second, and third bulk layers BOX1, BOX2, and BOX3 may undergo the etching process to form an inner gate dielectric layer IIL. The inner gate dielectric layer IIL may include an inner spacer ISP, an upper dielectric layer IILT, and a lower dielectric layer IILB. In the etching process, the inner spacer ISP may be formed to have a first thickness TH1, and the upper dielectric layer IILT or the lower dielectric layer IILB may be formed to have a second thickness TH2. The first thickness TH1 may be greater than the second thickness TH2.

The fourth bulk layer BOX4 may undergo the etching process to form an outer gate dielectric layer OIL. The outer gate dielectric layer OIL may be formed to have a uniform thickness. For example, the etching process may be performed to form a gate dielectric layer GI including the inner gate dielectric layer IIL and the outer gate dielectric layer OIL.

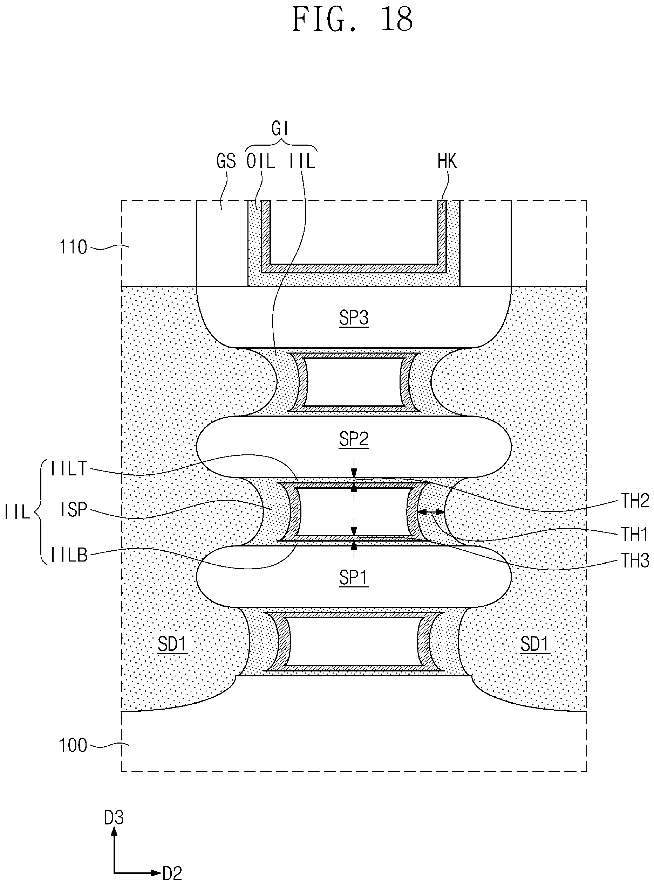

Referring to FIG. 18, a high-k dielectric layer HK is formed on each of the inner gate dielectric layer IIL and the outer gate dielectric layer OIL. As discussed above, the high-k dielectric layer HK includes a high-k dielectric material whose dielectric constant is greater than that of a silicon oxide layer. For example, the high-k dielectric material includes at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

For example, the high-k dielectric layer HK may be formed by performing an atomic layer deposition (ALD) process. The high-k dielectric layer HK may be conformally formed having a uniform thickness. The high-k dielectric layer HK may be formed to have a third thickness TH3. The first thickness TH 1 may be greater than the third thickness TH3. The first thickness TH1 may be greater than a sum of the second thickness TH2 and the third thickness TH3.

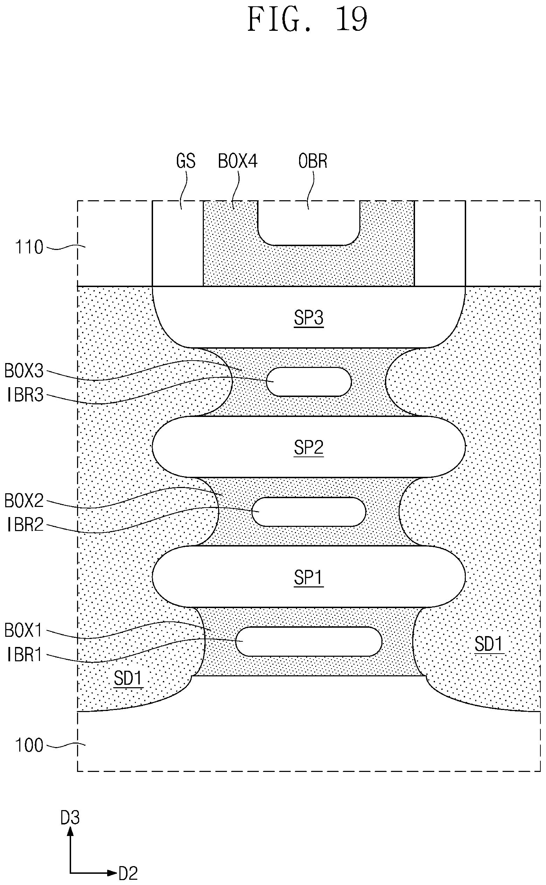

FIGS. 15, 18, and 19 to 22 illustrate enlarged views showing an example of a method of forming section M depicted in FIG. 13A. In detail, FIGS. 19 to 22 illustrate enlarged views of another example of FIGS. 16 and 17, showing another example of a method of forming section M depicted in FIG. 13A. In the implementation that follows, a detailed description of technical features repetitive to those discussed above with reference to FIGS. 15 to 18 will be omitted, and a difference thereof will be explained in detail.

Referring to FIG. 15, a selective wet etching process is performed through the outer region ORG formed between the gate spacers GS, thereby removing the sacrificial layers SAL. The first inner region IRG1 is formed between the substrate 100 and the first semiconductor pattern SP1. The second inner region IRG2 is formed between the first semiconductor pattern SP1 and the second semiconductor pattern SP2. The third inner region IRG3 is formed between the second semiconductor pattern SP2 and the third semiconductor pattern SP3.

Referring to FIG. 19, a bulk silicon oxide layer is formed in the first, second, and third inner regions IRG1, IRG2, and IRG3 and the outer region ORG. The bulk silicon oxide layer is formed on the first, second, and third semiconductor patterns SP1, SP2, and SP3. The bulk silicon oxide layer includes a first bulk layer BOX1, a second bulk layer BOX2, a third bulk layer BOX3, and a fourth bulk layer BOX4. The first to fourth bulk layers BOX1 to BOX4 are formed by performing an atomic layer deposition (ALD) process. The first to fourth bulk layers BOX1 to BOX4 include silicon oxide, silicon oxynitride, silicon oxycarbide, silicon nitride, silicon carbonitride, or a combination thereof. For example, the first to fourth bulk layers BOX1 to BOX4 may be a silicon oxide (SiOx) layer.

The first bulk layer BOX1 may be formed in the first inner region IRG1, and the second bulk layer BOX2 may be formed in the second inner region IRG2. The third bulk layer BOX3 may be formed in the third inner region IRG3, and the fourth bulk layer BOX4 may be formed on the outer region ORG. The first bulk layer BOX1, the second bulk layer BOX2, the third bulk layer BOX3, and the fourth bulk layer BOX4 may respectively include a first seam region IBR1, a second seam region IBR2, a third seam region IBR3, and a fourth seam region OBR.

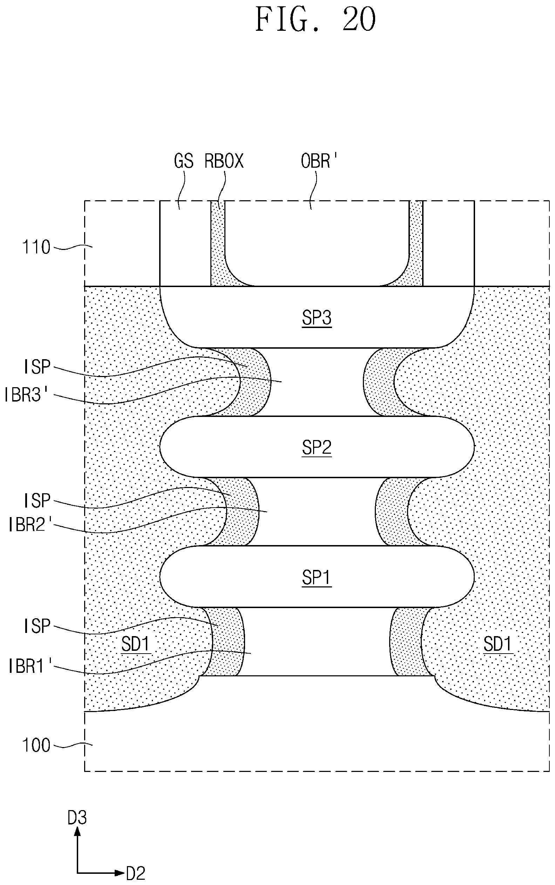

Referring to FIG. 20, an etching process is performed on the first to fourth bulk layers BOX1 to BOX4. The etching process is a composite process in which a dry etching process and a wet etching process are combined with each other. The etching process partially removes the bulk silicon oxide layer, or the first to fourth bulk layers BOX1 to BOX4. For example, the etching process is performed until surfaces of the first, second, and third semiconductor patterns SP1, SP2, and SP3 are exposed.

The first to fourth bulk layers BOX1 to BOX4 may undergo the etching process to completely remove portions of the first to fourth bulk layers BOX1 to BOX4 adjacent to the first to third semiconductor patterns SP1 to SP3. For example, portions of the first to fourth bulk layers BOX1 to BOX4 adjacent to the first source/drain pattern SD1 may remain without being removed.

After the etching process, an inner spacer ISP may be constituted by the first, second, and third bulk layers BOX1 to BOX3 that remain on a surface of the first source/drain pattern SD1. The fourth bulk layer BOX4 remaining on the gate spacer GS may be a residual dielectric layer RBOX having a tail part on the third semiconductor pattern SP3. The tail part may be a portion that extends on the third semiconductor pattern SP3 exposed on the gate spacer GS.

After the etching process, the first, second, third, and fourth seam regions IBR1, IBR2, IBR3, and OBR may expand adjacent to the first, second, and third semiconductor patterns SP1, SP2, and SP3. Thus, the expanded first seam region IBR1 may be a fifth seam region IBR1'. The expanded second seam region IBR2 may be a sixth seam region IBR2'. The expanded third seam region IBR3 may be a seventh seam region IBR3'. The expanded fourth seam region OBR may be an eighth seam region OBR'.

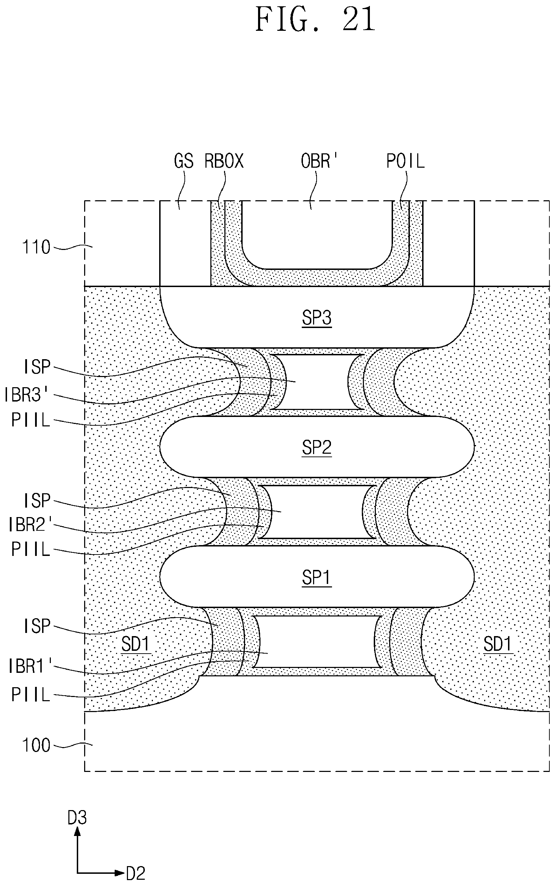

Referring to FIG. 21, the fifth to eighth seam regions IBR1', IBR2', IBR3', and OBR' undergo the deposition process discussed above. A preliminary outer dielectric layer POIL and a preliminary inner dielectric layer PIIL are additionally deposited in the fifth to eighth seam regions IBR1', IBR2', IBR3', and OBR'. The preliminary outer dielectric layer POIL extends from the exposed third semiconductor pattern SP3 onto the residual dielectric layer RBOX. The preliminary inner dielectric layer PIIL covers the first, second, and third semiconductor patterns SP1, SP2, and SP3 and the inner spacer ISP.

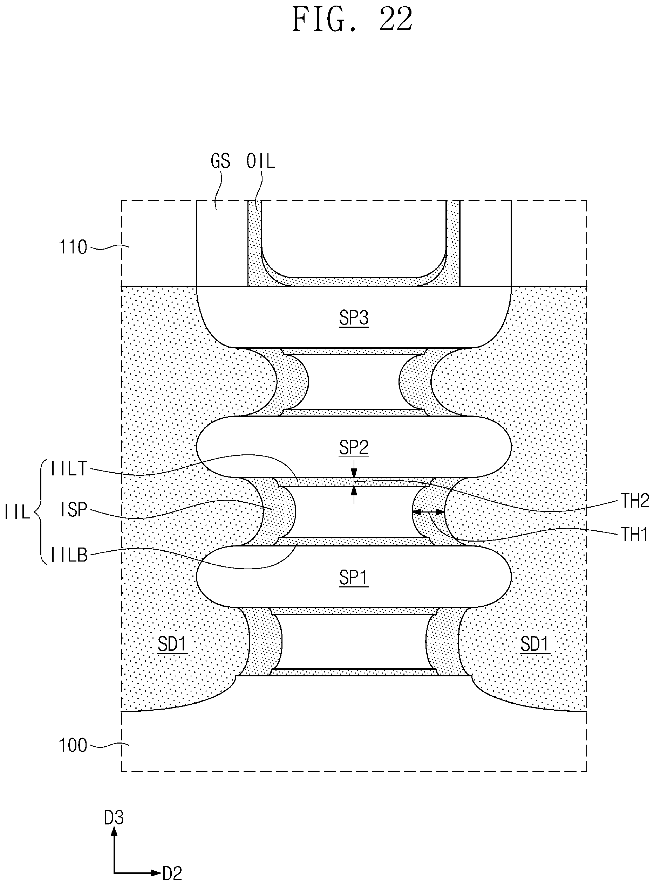

Referring to FIGS. 22, the preliminary outer dielectric layer POIL and the preliminary inner dielectric layer PIIL undergo the etching process discussed above. The etching process is a composite process in which a dry etching process and a wet etching process are combined with each other. The etching process is performed to partially remove the preliminary outer dielectric layer POIL and the preliminary inner dielectric layer PIIL. After the removal of the preliminary outer dielectric layer POIL and the preliminary inner dielectric layer PIIL, remaining layers are an upper dielectric layer IILT, a lower dielectric layer IILB, and an outer gate dielectric layer OIL.

For example, the upper dielectric layer IILT and the lower dielectric layer IILB may be formed on the first, second, and third semiconductor patterns SP1, SP2, and SP3 in the fifth, sixth, and seventh seam regions IBR1', IBR2', and IBR3'. The upper dielectric layer IILT and the lower dielectric layer IILB may include silicon oxide, silicon oxynitride, silicon oxycarbide, silicon nitride, silicon carbonitride, or a combination thereof. For example, the inner spacer ISP, the upper dielectric layer IILT, and the lower dielectric layer IILB may include the same material. For another example, the inner spacer ISP, the upper dielectric layer IILT, and the lower dielectric layer IILB may include different materials from each other.

According to the present implementation, differently from the implementation of FIGS. 16 and 17, the inner spacer ISP, the upper dielectric layer IILT, and the lower dielectric layer IILB may not be formed at the same time.

The deposition process and the etching process may constitute one cyclic process. According to some implementations, the cyclic process may be performed at least twice as discussed above with reference to FIGS. 15 and 19 to 22. The cyclic process may be repeatedly performed to allow the inner spacer ISP to have a target thickness.

An inner gate dielectric layer IIL may be constituted by the inner spacer ISP, the upper dielectric layer IILT, and the lower dielectric layer IILB. In the etching process, the inner spacer ISP may be formed to have a first thickness TH1, and the upper dielectric layer IILT or the lower dielectric layer IILB may be formed to have a second thickness TH2. The first thickness TH1 may be greater than the second thickness TH2.

An outer gate dielectric layer OIL may be constituted by the residual dielectric layer RBOX and the preliminary outer dielectric POIL The outer gate dielectric layer OIL may be formed to have a uniform thickness. For example, the etching process may be performed to form a gate dielectric layer GI including the inner gate dielectric layer IIL and the outer gate dielectric layer OIL.

Although not shown, according to some implementations, the outer gate dielectric layer OIL may be constituted by only a remaining preliminary outer dielectric layer POIL. For example, the outer gate dielectric layer OIL may be formed only on the exposed third semiconductor pattern SP3. The outer gate dielectric layer OIL may be formed only on the third semiconductor pattern SP3, may not extend onto the gate spacer GS.

Referring to FIG. 18, a high-k dielectric layer HK is formed on each of the inner gate dielectric layer IIL and the outer gate dielectric layer OIL. As discussed above, the high-k dielectric layer HK includes a high-k dielectric material whose dielectric constant is greater than that of a silicon oxide layer. For example, the high-k dielectric material may include at least one selected from hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

For example, the high-k dielectric layer HK may be formed by performing an atomic layer deposition (ALD) process. The high-k dielectric layer HK may be conformally formed having a uniform thickness. The high-k dielectric layer HK may be formed to have a third thickness TH3. The first thickness TH 1 may be greater than the third thickness TH3. The first thickness TH1 may be greater than a sum of the second thickness TH2 and the third thickness TH3.

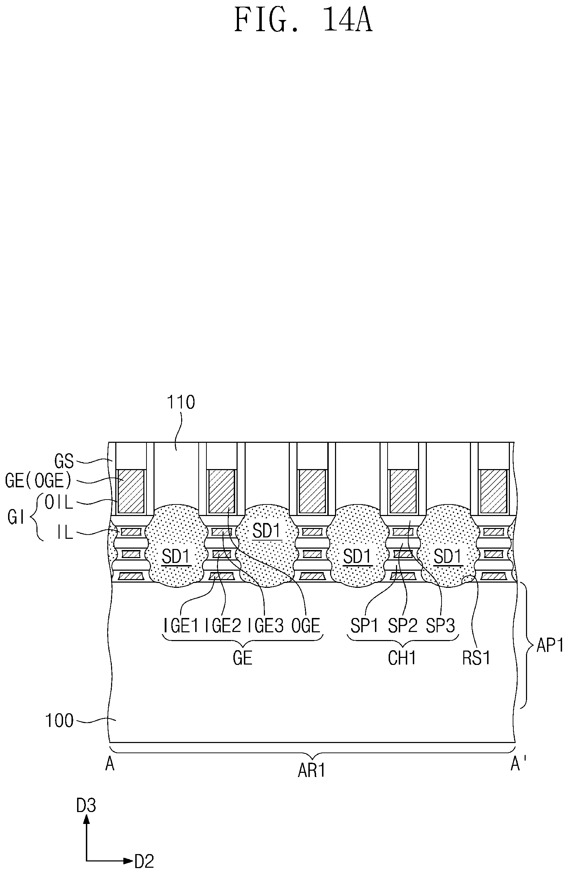

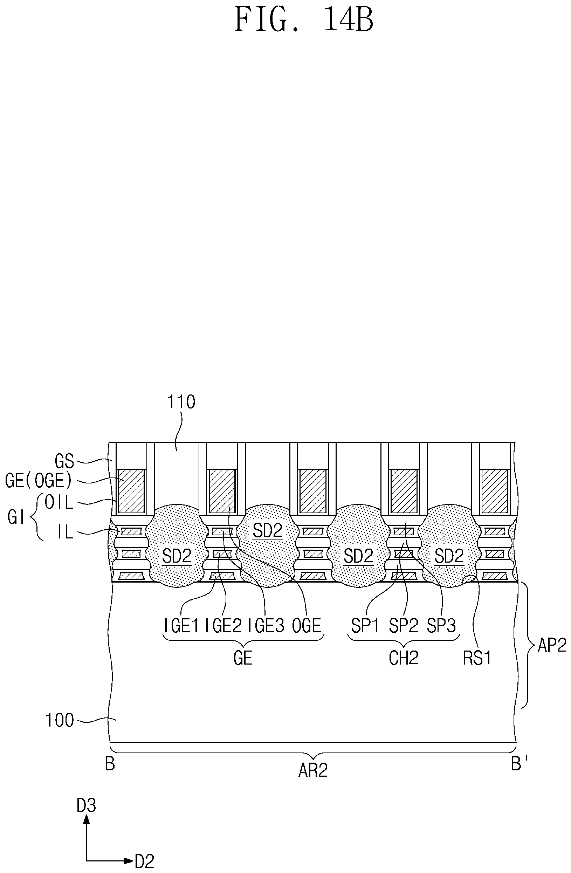

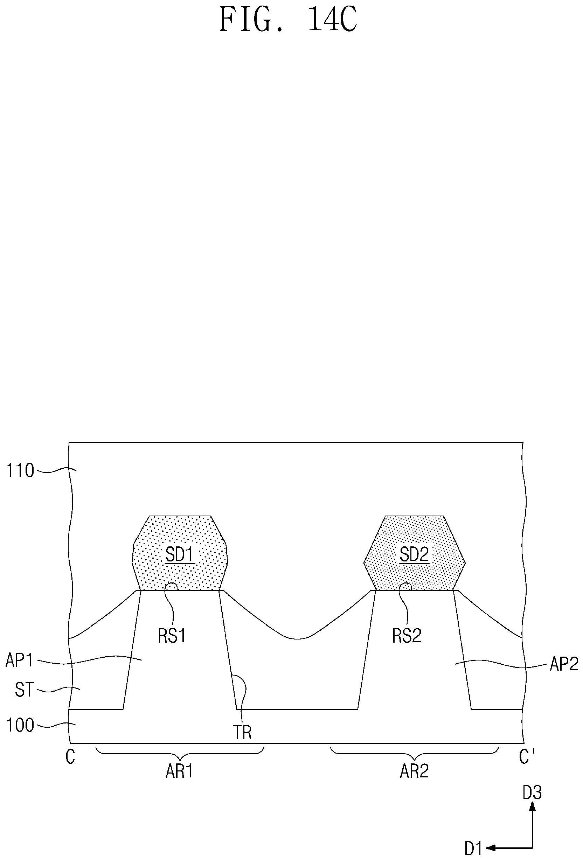

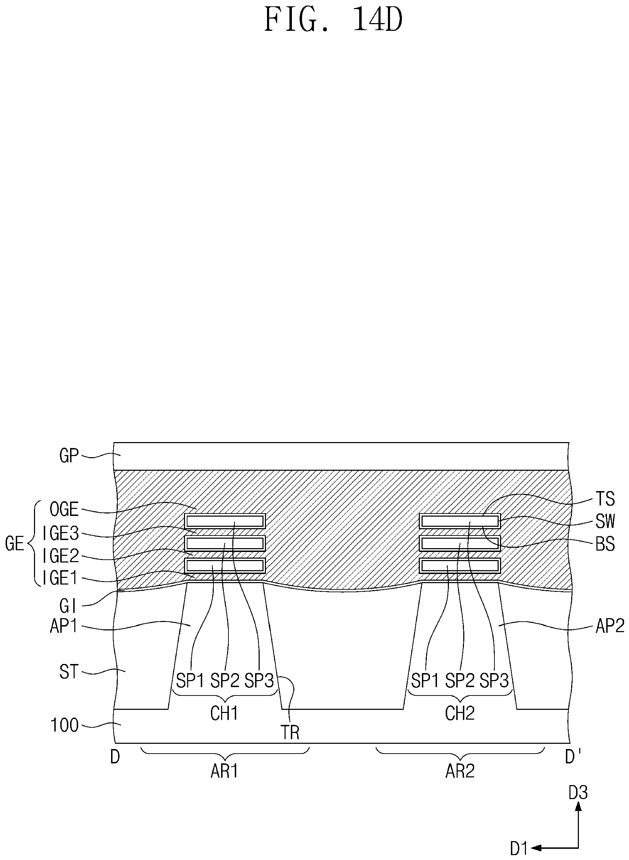

Referring to FIGS. 14A to 14D, a gate electrode GE is formed on the gate dielectric layer GI. For example, the gate electrode GE is formed on the high-k dielectric layer (see HK of FIG. 6A). For example, the high-k dielectric layer HK is formed on the gate dielectric layer GI, and the gate electrode GE is formed on the high-k dielectric layer HK. The gate electrode GE includes first, second, and third inner gate electrodes IGE1, IGE2, and IGE3 that are correspondingly formed in the first, second, and third inner regions IRG1, IRG2, and IRG3, and also includes an outer gate electrode OGE formed in the outer region ORG. The gate electrode GE is recessed to have a reduced height. A gate capping pattern GP is formed on the recessed gate electrode GE.

Referring back to FIGS. 5A to 5D, a second interlayer dielectric layer 120 is formed on the first interlayer dielectric layer 110. The second interlayer dielectric layer 120 includes a silicon oxide layer. Active contacts AC is formed to penetrate the second and first interlayer dielectric layers 120 and 110 to come into electrical connection with the first and second source/drain patterns SD1 and SD2. A gate contact GC is formed to penetrate the second interlayer dielectric layer 120 and the gate capping pattern GP to come into electrical connection with the gate electrode GE.

The formation of each of the active contact AC and the gate contact GC may include forming a barrier pattern BM and forming a conductive pattern FM on the barrier pattern BM. The barrier pattern BM may be conformally formed to include a metal layer and a metal nitride layer. The conductive pattern FM may include metal whose resistance is low.

Separation structures DB may be correspondingly formed on first and second boundaries BD1 and BD2 of the single height cell SHC. The separation structure DB may extend from the second interlayer dielectric layer 120 through the gate electrode GE into the active pattern AP1 or AP2. The separation structure DB may include a dielectric material, such as a silicon oxide layer or a silicon nitride layer.

A third interlayer dielectric layer 130 may be formed on the active contacts AC and the gate contacts GC. A first metal layer M1 may be formed in the third interlayer dielectric layer 130. A fourth interlayer dielectric layer 140 may be formed on the third interlayer dielectric layer 130. A second metal layer M2 may be formed in the fourth interlayer dielectric layer 140.

In a three-dimensional field effect transistor according to the present concepts, a gate dielectric on a lateral surface of the gate electrode, e.g., gate electrode GE, may serve as an inner spacer, e.g., inner spacer ISP, and thus there may an increase in distance between a source/drain pattern, e.g., source/drain pattern SD1, and an inner gate electrode, e.g., second inner gate electrode IGE2, of the gate electrode. The increase in distance between the source/drain pattern and the inner gate electrode may reduce a capacitor/gate leakage current. In addition, a stress applied from the source/drain pattern to a channel may be effectively adjusted to increase mobility of carrier. For example, the source/drain pattern may have a lattice constant which is equal to a lattice constant of semiconductor patterns of a channel pattern, and greater than a lattice constant of the inner spacer. This may result in an applied stress from the source/drain pattern to the channel pattern to increase carrier mobility. Additionally, as the inner spacer is formed after the source/drain pattern is formed, a semiconductor may increase in reliability and electrical properties.

In a three-dimensional field effect transistor according to the present concepts, in each of a plurality of elements, the presence or absence of an inner spacer may be implemented to effectively control capacitance of each of the plurality of elements. For example, based on the absence or absence of inner spacers in a plurality of elements, a target value of capacitance may be set for each element to optimize an operation of a semiconductor device. A semiconductor device according to the present concepts may consequently increase in electrical properties.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

Although the concepts described herein have been described in connection with implementations of the present disclosure illustrated in the accompanying drawings, it will be understood by one of ordinary skill in the art that variations in form and detail may be made therein without departing from essential feature(s) of the present disclosure. The above disclosed implementations should thus be considered illustrative and not restrictive.

## Claims

1. A semiconductor device, comprising:
a substrate comprising an active pattern;
a channel pattern on the active pattern, wherein the channel pattern comprises a plurality of semiconductor patterns that are vertically stacked and spaced apart from each other;
a source/drain pattern connected to the plurality of semiconductor patterns;
an inner gate electrode between a first semiconductor pattern and a second semiconductor pattern, wherein the first semiconductor pattern and the second semiconductor pattern are two neighboring semiconductor patterns of the plurality of semiconductor patterns;
an inner gate dielectric layer; and
an inner high-k dielectric layer between the inner gate electrode and the inner gate dielectric layer,
wherein the inner gate dielectric layer comprises:
an upper dielectric layer between the inner gate electrode and the second semiconductor pattern;
a lower dielectric layer between the inner gate electrode and the first semiconductor pattern; and
an inner spacer between the inner gate electrode and the source/drain pattern,
wherein a first thickness of the inner spacer is greater than a second thickness of the upper dielectric layer or of the lower dielectric layer, and
wherein the first thickness is greater than a third thickness of the inner high-k dielectric layer.

2. The semiconductor device of claim 1, wherein the first thickness is greater than a sum of the second thickness and the third thickness.

3. The semiconductor device of any preceding claim, wherein the first thickness is in a range of 10.0 Å to 25.0 Å.

4. The semiconductor device of any preceding claim, wherein
the second thickness is in a range of 5.0 Å to 10.0 Å, and
the third thickness is in a range of 5.0 Å to 10.0 Å.

5. The semiconductor device of claim 4, wherein the third thickness is greater than the second thickness.

6. The semiconductor device of claim 4, wherein the second thickness and the third thickness are equal.

7. The semiconductor device of any preceding claim, wherein a sidewall of the source/drain pattern comprises a concave part and a convex part,
wherein the concave part and the convex part are disposed alternately with each other, and
wherein the sidewall has a wavy profile.

8. The semiconductor device of claim 7, wherein the convex part is a portion where a sidewall of the inner spacer is in contact with the sidewall of the source/drain pattern.

9. The semiconductor device of claim 7 or 8, wherein the concave part is a portion where a sidewall of each semiconductor pattern of the plurality of semiconductor patterns is in contact with the sidewall of the source/drain pattern.

10. The semiconductor device of any of claims 7 to 9, wherein a curvature of the convex part is a same as or less than a curvature of the concave part.

11. The semiconductor device of any preceding claim, wherein the inner spacer comprises a silicon oxide layer or a silicon oxynitride layer.

12. The semiconductor device of any preceding claim, wherein a width in a first direction of the channel pattern is greater than a width in the first direction of the inner gate dielectric layer.

13. The semiconductor device of any preceding claim, comprising:
an outer gate electrode on an uppermost semiconductor pattern of the plurality of semiconductor patterns; and
an outer gate dielectric layer adjacent to the outer gate electrode,
wherein the outer gate dielectric layer has a uniform thickness.

14. The semiconductor device of claim 13, comprising an outer high-k dielectric layer between the outer gate electrode and the outer gate dielectric layer.

15. A semiconductor device, comprising:
a substrate comprises an active pattern;
a channel pattern on the active pattern, wherein the channel pattern comprises a plurality of semiconductor patterns that are vertically stacked and spaced apart from each other;
a source/drain pattern connected to the plurality of semiconductor patterns;
a gate electrode, wherein the gate electrode comprises an inner gate electrode between two neighboring semiconductor patterns of the plurality of semiconductor patterns and the gate electrode comprises an outer gate electrode on an uppermost semiconductor pattern of the plurality of semiconductor patterns; and
an inner spacer between the inner gate electrode and the source/drain pattern,
wherein each semiconductor pattern of the plurality of semiconductor patterns has a first lattice constant,
wherein the source/drain pattern has a second lattice constant,
wherein the inner spacer has a third lattice constant, and
wherein the second lattice constant equals the first lattice constant and is greater than the third lattice constant.
